(19) Europäisches Patentamt
European Patent Office
Office européen des brevets

(11) **EP 4 657 890 A1**

(12) **DEMANDE DE BREVET EUROPEEN**

(43) Date de publication:
**03.12.2025   Bulletin 2025/49**

(21) Numéro de dépôt: **25178633.1**

(22) Date de dépôt: **23.05.2025**

(51) Classification Internationale des Brevets (IPC):
**H04R 19/00** (2006.01)      **B81B 3/00** (2006.01)
**H04R 19/01** (2006.01)      **B81B 5/00** (2006.01)

(52) Classification Coopérative des Brevets (CPC):
**H04R 19/005; B81B 3/0027;** B81B 5/00;
B81B 2201/0257; H04R 2201/003

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité:   **27.05.2024   FR 2405415**

(71) Demandeur: **Commissariat à l'Energie Atomique
et aux Energies
Alternatives
75015 Paris (FR)**

(72) Inventeur: **JOET, Loïc
38054 GRENOBLE CEDEX 09 (FR)**

(74) Mandataire: **Cabinet Camus Lebkiri
25 rue de Maubeuge
75009 Paris (FR)**

(54) **SYSTEME ÉLECTROMÉCANIQUE COMPRENANT UN ÉLÉMENT MOBILE MUNI D'UNE OUVERTURE**

(57)   L'invention concerne un système électromécanique comprenant :
- un bâti ;
- un élément mobile (13) par rapport au bâti, l'élément mobile comprenant une membrane (131) et une structure de rigidification (132) de la membrane ;
- des moyens capacitifs de mesure ou d'actionnement ;
- un premier dispositif de transmission (14a) d'un mouvement entre l'élément mobile (13) et les moyens de mesure ou d'actionnement, le premier dispositif de transmission (14a) étant mobile en rotation par rapport au bâti au moyen d'une pluralité de premières articulations pivot (16a) ;
système dans lequel :
- une première ouverture (134) est aménagée dans l'élément mobile (13) ;
- le bâti comprend un premier îlot (110) s'étendant à l'intérieur de la première ouverture (134) ; et
- le premier dispositif de transmission (14a) est relié au premier îlot (110) par l'intermédiaire de l'une des premières articulations pivot (16a).

Fig. 7A

**Description**

**DOMAINE TECHNIQUE DE L'INVENTION**

Le domaine technique de l'invention est celui des systèmes électromécaniques, notamment de type microsystème électromécanique (MEMS, pour « microelectromechanical systems » en anglais) ou nanosystème électromécanique (NEMS, pour « nanoelectromechanical system »). L'invention concerne plus particulièrement un système électromécanique comprenant un élément mobile, des moyens capacitifs de mesure ou d'actionnement et un dispositif de transmission d'un mouvement entre l'élément mobile et les moyens capacitifs de mesure ou d'actionnement. Un tel système peut être employé en tant que transducteur électroacoustique (ex. microphone, haut-parleur...) ou capteur de pression différentielle.

**ARRIERE-PLAN TECHNOLOGIQUE DE L'INVENTION**

Les microphones en microélectromécanique ou nanoélectromécanique représentent un marché en pleine expansion, notamment grâce au développement des appareils nomades, tels que les tablettes, téléphones portables intelligents (smartphones) et aux autres objets connectés, dans lesquels ils remplacent peu à peu les microphones à électret.

Les microphones mesurent une variation rapide de la pression atmosphérique, aussi appelée pression acoustique. Ils comportent donc au moins une partie en contact avec l'extérieur.

La plupart des microphones MEMS ou NEMS fabriqués actuellement sont des microphones à détection capacitive. La figure 1 représente un exemple de microphone à détection capacitive 1, décrit dans le brevet FR3114584B1.

Le microphone 1 comprend un bâti (non représenté) délimitant au moins en partie une première zone 11 et une deuxième zone 12, un élément mobile 13 par rapport au bâti et un dispositif de transmission 14 d'un mouvement entre la première zone 11 et la deuxième zone 12. Les première et deuxième zones 11-12 du microphone 1 sont isolées l'une de l'autre de manière étanche.

L'élément mobile 13, aussi appelé piston, est en contact avec la première zone 11. Il comprend une membrane 131 et une structure de rigidification 132 de la membrane. La membrane 131 du piston 13 a pour rôle de récolter sur toute sa surface une différence de pression entre ses deux faces, pour en déduire une variation de la pression atmosphérique. Une face de la membrane 131 est soumise à la pression atmosphérique (dont on souhaite détecter la variation) et une face opposée de la membrane 131 est soumise à une pression de référence.

En outre, le microphone 1 comprend des moyens de détection capacitive 15 disposés dans la deuxième zone 12. Ces moyens de détection capacitive 15 permettent de mesurer le déplacement du piston 13, et donc la différence de pression entre ses deux faces. Ils comprennent de préférence une électrode mobile 151 et au moins une électrode fixe disposée en regard de l'électrode mobile 151. Les électrodes forment les armatures d'un condensateur dont la capacité varie en fonction du déplacement du piston 13.

Le dispositif de transmission 14 est monté mobile en rotation par rapport au bâti, au moyen de plusieurs articulations pivot 16. Le dispositif de transmission 14 comprend deux premiers bras de transmission 141 s'étendant dans la première zone 11, deux deuxièmes bras de transmission 142 s'étendant dans la deuxième zone 12 et deux arbres de transmission 143 s'étendant en partie dans la première zone 11 et en partie dans la deuxième zone 12. Chaque arbre de transmission 143 relie un premier bras de transmission 141 à un deuxième bras de transmission 142.

Chaque premier bras de transmission 141 comprend une première extrémité couplée au piston 13 et une deuxième extrémité opposée, couplée à l'arbre de transmission 143 associé. Chaque deuxième bras de transmission 142 comprend une première extrémité couplée à l'électrode mobile 151 des moyens de détection capacitive 15 et une deuxième extrémité opposée, couplée à l'arbre de transmission 143 associé.

Le brevet FR3059659B1 décrit un microphone à détection capacitive semblable à celui de la figure 1. Les moyens de détection capacitive comprennent une électrode mobile et deux électrodes fixes entre lesquelles est disposée l'électrode mobile. Les électrodes forment les armatures de deux condensateurs dont les capacités varient dans des sens opposés en fonction du déplacement du piston. La mesure du déplacement du piston est alors une mesure différentielle.

Pour réaliser une telle mesure différentielle, les condensateurs sont au préalable chargés en appliquant une tension de polarisation continue entre l'électrode mobile et les électrodes fixes par l'intermédiaire d'une forte résistance. Le déplacement du piston se traduit par une variation des capacités, et donc une variation de la tension entre les électrodes fixes (la charge des condensateurs étant sensiblement constante aux fréquences audibles, typiquement supérieures à 100 Hz) qui peut être lue par un amplificateur d'instrumentation.

Ces microphones à détection capacitive peuvent devenir défaillants à cause d'un phénomène d'effondrement de l'électrode mobile, appelé « pull-in » en anglais et commun à tous les systèmes électromécaniques comprenant des moyens capacitifs de mesure ou d'actionnement. Ce phénomène d'effondrement est causé par la force électrostatique, qui tend à rapprocher l'électrode mobile de l'électrode fixe (ou de l'une des électrode fixes) et qui dépend du carré de la tension de polarisation. La force électrostatique, qui dépend aussi du déplacement de l'électrode mobile, peut être approximée au premier ordre par une force constante plus la force exercée par un ressort de raideur négative pour de petits déplacements.

Pour éviter (jusqu'à un certain point) ce phénomène d'effondrement, une force élastique est opposée à la force électrostatique. Cette force élastique peut être générée par des ressorts reliant le cadre de l'électrode mobile 151 au bâti du microphone 1. Plus la raideur des ressorts est importante, plus la valeur de tension à laquelle la force électrostatique surpasse la force élastique (tension dite d'effondrement ou « pull-in voltage » en anglais) est importante et plus l'électrode mobile 151 peut être polarisée à une tension élevée. Ceci est avantageux car la sensibilité du microphone 1 augmente avec la tension de polarisation.

Un inconvénient des microphones à détection capacitive décrits ci-dessus est que de l'énergie est perdue dans la déformation du piston 13, du dispositif de transmission 14 et du cadre de l'électrode mobile 151, ce qui représente une perte de signal utile lors de la détection des variations dynamiques de pression. Une solution pour diminuer ces pertes d'énergie, et donc augmenter la sensibilité du microphone, consisterait à renforcer la structure de rigidification 132 du piston 13, le dispositif de transmission 14 et le cadre de l'électrode mobile 151. Toutefois, cette solution augmenterait considérablement la masse de ces parties mobiles, diminuant la fréquence de résonnance du microphone.

**RESUME DE L'INVENTION**

Il existe donc un besoin de prévoir un système électromécanique à détection capacitive ou actionnement capacitif qui présente de meilleures performances, notamment en termes de sensibilité et de fréquence de résonance.

Selon l'invention, on tend à satisfaire ce besoin en prévoyant un système électromécanique comprenant :

- un bâti ;

- un élément mobile par rapport au bâti, l'élément mobile comprenant une membrane et une structure de rigidification de la membrane ;

- des moyens capacitifs de mesure ou d'actionnement ; et

- un premier dispositif de transmission d'un mouvement entre l'élément mobile et les moyens capacitifs de mesure ou d'actionnement, le premier dispositif de transmission étant mobile en rotation par rapport au bâti au moyen d'une pluralité de premières articulations pivot.

Ce système électromécanique est remarquable en ce que :

- une première ouverture est aménagée dans l'élément mobile ;

- le bâti comprend un premier îlot s'étendant à l'intérieur de la première ouverture ; et

- le premier dispositif de transmission est relié au premier îlot par l'intermédiaire de l'une des premières articulations pivot.

De préférence, une portion du premier îlot forme une butée permettant de limiter un déplacement de l'élément mobile. La butée est de préférence formée par une portion périphérique du premier îlot.

La structure de rigidification de l'élément mobile peut comprendre deux doigts et le premier îlot peut comprendre un doigt configuré pour venir en appui contre la membrane de l'élément mobile entre les deux doigts de la structure de rigidification.

Le premier dispositif de transmission comprend de préférence :

- un premier arbre de transmission présentant un premier axe longitudinal de rotation ;

- au moins un premier bras de transmission comprenant une première extrémité couplée à l'élément mobile et une deuxième extrémité solidaire du premier arbre de transmission.

Dans un mode de réalisation préférentiel, le premier arbre de transmission comprend une première portion qui s'étend jusqu'aux moyens capacitifs de mesure ou d'actionnement et une deuxième portion reliée au premier îlot, les première et deuxième portions du premier arbre de transmission étant distinctes.

Selon un premier développement de ce mode de réalisation préférentiel, le système comprend une première articulation entre l'élément mobile et le premier dispositif de transmission et le premier dispositif de transmission comprend deux premier bras de transmission convergeant vers la première articulation, l'un des deux premiers bras de transmission s'étendant depuis la première portion du premier arbre de transmission et l'autre des deux premiers bras de transmission s'étendant depuis la deuxième portion du premier arbre de transmission.

Selon un deuxième développement compatible avec le premier :

- le premier arbre de transmission est situé d'un premier côté de la membrane de l'élément mobile ;

- la structure de rigidification de l'élément mobile comprend une première poutre située du premier côté de la membrane ; et

- les première et deuxième portions du premier arbre de transmission sont séparées par la première poutre.

Avantageusement, la première poutre s'étend dans une direction perpendiculaire au premier axe longitudinal de rotation et présente une longueur supérieure ou égale à 50 % de la dimension de l'élément mobile mesurée dans ladite direction.

La structure de rigidification de l'élément mobile peut comprendre deux premières poutres situées du premier côté de la membrane et s'étendant en parallèle l'une de l'autre et la deuxième portion du premier arbre de transmission peut être située entre les deux premières poutres.

La structure de rigidification de l'élément mobile peut comprendre en outre une deuxième poutre située d'un deuxième côté opposé de la membrane et superposée à la première poutre.

La structure de rigidification de l'élément mobile peut comprendre en outre des arêtes situées d'un deuxième côté opposé de la membrane et s'étendant perpendiculairement à la première poutre.

Outre les caractéristiques qui viennent d'être évoquées dans les paragraphes précédents, le système électromécanique selon l'invention peut présenter une ou plusieurs caractéristiques complémentaires parmi les suivantes, considérées individuellement ou selon toutes les combinaisons techniquement possibles :

- l'élément mobile est en translation par rapport au bâti ;

- l'élément mobile est en rotation par rapport au bâti ;

- le bâti comprend un capot muni d'une ouverture pour donner accès à l'élément mobile et le capot comprend un premier bras s'étendant dans l'ouverture jusqu'au premier îlot ;

- plusieurs premières ouvertures sont aménagées dans l'élément mobile, le bâti comprend plusieurs premiers îlots, chaque premier îlot s'étendant à l'intérieur de l'une des premières ouvertures et le premier dispositif de transmission est relié à une partie au moins des premiers îlots par l'intermédiaire d'une partie des premières articulations pivot ;

- les moyens capacitifs de mesure ou d'actionnement comprennent :

  - une première électrode mobile par rapport au bâti ; et

  - au moins une électrode fixe par rapport au bâti et séparée de la première électrode mobile par un premier milieu diélectrique ;

- la première électrode mobile est reliée au premier arbre de transmission ;

- la première électrode mobile est solidaire du premier arbre de transmission, d'où il résulte que la première électrode mobile est montée mobile en rotation autour du premier axe longitudinal de rotation ;

- l'élément mobile est en contact avec une première zone et la première électrode mobile est située dans une deuxième zone isolée de manière étanche de la première zone ;

- au moins une des premières articulations pivot est située au niveau de la première électrode mobile ;

- une autre des premières articulations pivot est située à une extrémité du premier dispositif de transmission et relie le premier dispositif de transmission au premier îlot ;

- le système comprend en outre un deuxième dispositif de transmission de mouvement entre l'élément mobile et les moyens capacitifs de mesure ou d'actionnement, le deuxième dispositif de transmission étant mobile en rotation par rapport au bâti au moyen d'une pluralité de deuxièmes articulations pivot ;

- une deuxième ouverture est aménagée dans l'élément mobile, le bâti comprend un deuxième îlot s'étendant à l'intérieur de la deuxième ouverture et le deuxième dispositif de transmission de mouvement est relié au deuxième îlot par l'intermédiaire de l'une des deuxièmes articulations pivot ;

- une portion du deuxième îlot forme une butée permettant de limiter un déplacement de l'élément mobile ;

- le capot comprend un deuxième bras s'étendant dans l'ouverture jusqu'au deuxième îlot ;

- plusieurs deuxièmes ouvertures sont aménagées dans l'élément mobile, le bâti comprend plusieurs deuxièmes îlots, chaque deuxième îlot s'étendant à l'intérieur de l'une des deuxièmes ouvertures et le deuxième dispositif de transmission est relié à une partie au moins des deuxièmes îlots par l'intermédiaire d'une partie des deuxièmes articulations pivot ;

- le deuxième dispositif de transmission comprend :

  - un deuxième arbre de transmission présentant un deuxième axe longitudinal de rotation ;
  - au moins un deuxième bras de transmission comprenant une première extrémité couplée à l'élément mobile et une deuxième extrémité solidaire du deuxième arbre de transmission ;

- les moyens capacitifs de mesure ou d'actionnement comprennent en outre :

  - une deuxième électrode mobile par rapport au bâti ; et

  - au moins une électrode additionnelle fixe par rapport au bâti et séparée de la deuxième électrode mobile par un deuxième milieu diélectrique ;

- la deuxième électrode mobile est reliée au deuxième arbre de transmission ;

- la deuxième électrode mobile est solidaire du deuxième arbre de transmission, d'où il résulte que la deuxième électrode mobile est montée mobile en rotation autour du deuxième axe longitudinal de rotation ;

- la deuxième électrode mobile est située dans la deuxième zone ;

- au moins une des deuxième articulations pivot est située au niveau de la première électrode mobile ; et

- une autre des premières articulations pivot est située à une extrémité du premier dispositif de transmission et relie le premier dispositif de transmission au premier îlot.

**BREVE DESCRIPTION DES FIGURES**

D'autres caractéristiques et avantages de l'invention ressortiront clairement de la description qui en est donnée ci-dessous, à titre indicatif et nullement limitatif, en référence aux figures annexées, parmi lesquelles :

- la figure 1 est une vue en perspective partielle d'un microphone à détection capacitive selon l'art antérieur ;

- la figure 2 est une vue de dessous partielle d'un système électromécanique selon un premier mode de réalisation, ce système électromécanique comprenant des moyens capacitifs de détection ou d'actionnement ;

- la figure 3 est une vue de dessus partielle des moyens capacitifs de détection ou d'actionnement du système électromécanique de la figure 2 ;

- la figure 4A est une vue en coupe du système électromécanique selon le plan de coupe A-A de la figure 3 ;

- la figure 4B est une vue en coupe du système électromécanique selon le plan de coupe C-C de la figure 3 ;

- la figure 5 est une vue de dessous partielle d'un système électromécanique selon un deuxième mode de réalisation ;

- la figure 6 est une vue de dessus partielle du système électromécanique de la figure 5 ;

- les figures 7A et 7B représentent une partie d'un îlot s'étendant à travers l'élément mobile du système électromécanique des figures 5 et 6 ;

- la figure 8 représente un premier exemple de capot auquel est fixé l'îlot des figures 7A-7B ;

- la figure 9 représente un deuxième exemple de capot auquel est fixé l'îlot des figures 7A-7B ; et

- la figure 10 est une vue de dessous partielle d'un système électromécanique selon un troisième mode de réalisation.

Pour plus de clarté, les éléments identiques ou similaires sont repérés par des signes de référence identiques sur l'ensemble des figures.

## DESCRIPTION DETAILLEE

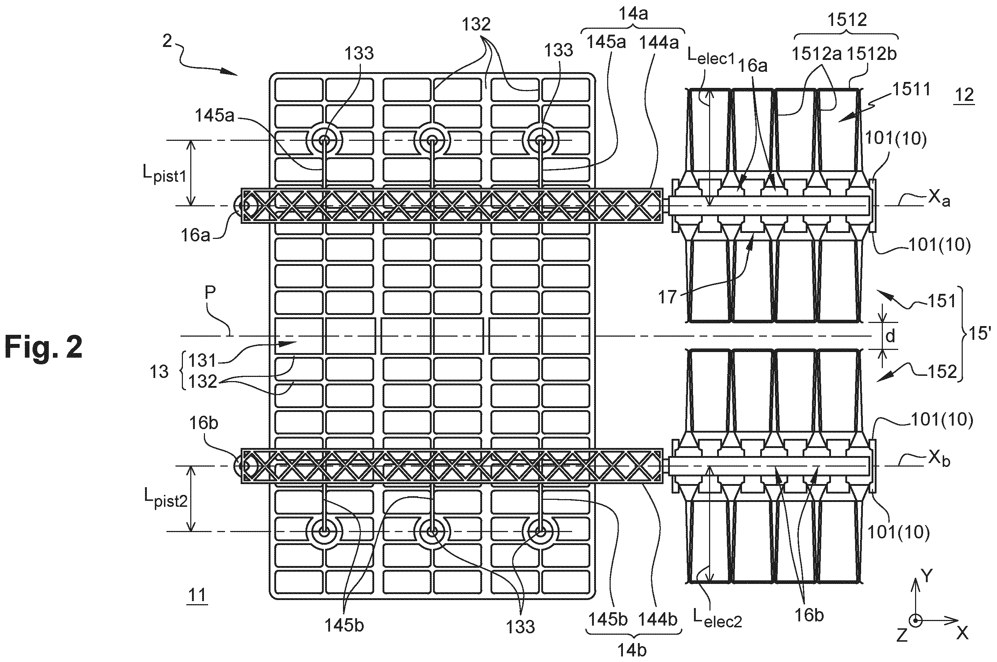

Les figures 2, 3 et 4A à 4B représentent une partie d'un système électromécanique 2 à détection capacitive ou actionnement capacitif selon un premier mode de réalisation. Ce système électromécanique 2 peut former un transducteur électroacoustique, par exemple un microphone ou un haut-parleur, ou un capteur de pression différentielle. Dans la description qui suit, on prendra l'exemple d'un microphone à détection capacitive.
Le système électromécanique 2 comprend :

- un bâti 10 ;

- un élément mobile 13 en contact avec une première zone 11 ;

- des moyens de détection (ou mesure) capacitive 15' comprenant une première électrode 151 mobile par rapport au bâti 10, une deuxième électrode 152 mobile par rapport au bâti 10, les première et deuxième électrodes mobiles 151-152 étant situées dans une deuxième zone 12 isolée de manière étanche de la première zone 11 ; et

- un premier dispositif de transmission 14a d'un mouvement entre l'élément mobile 13 et la première électrode mobile 151 (autrement dit entre la première zone 11 et la deuxième zone 12) ; et

- un deuxième dispositif de transmission 14b d'un mouvement entre l'élément mobile 13 et la deuxième électrode mobile 152.

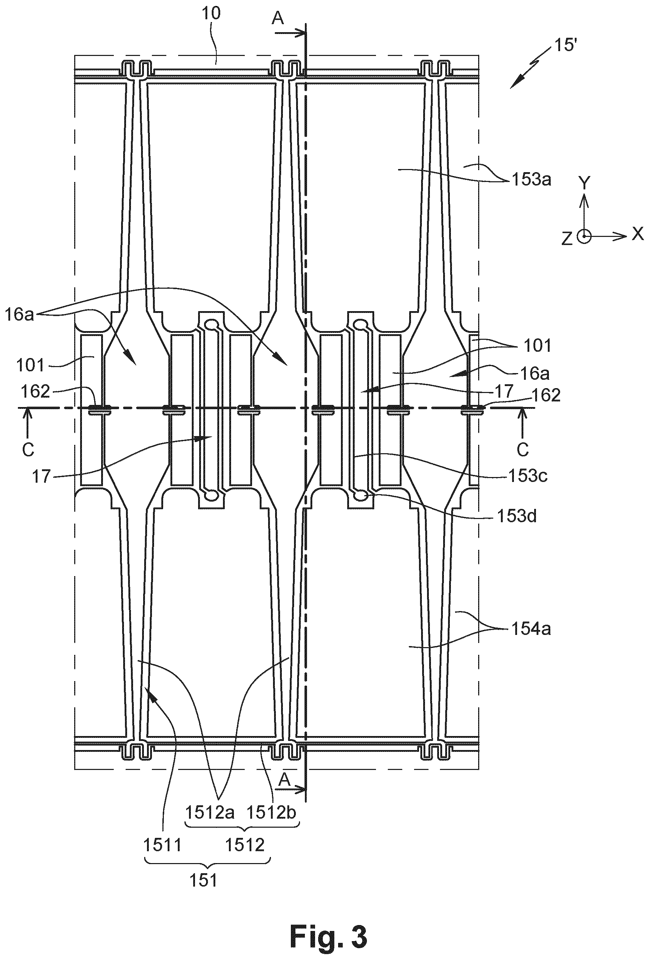

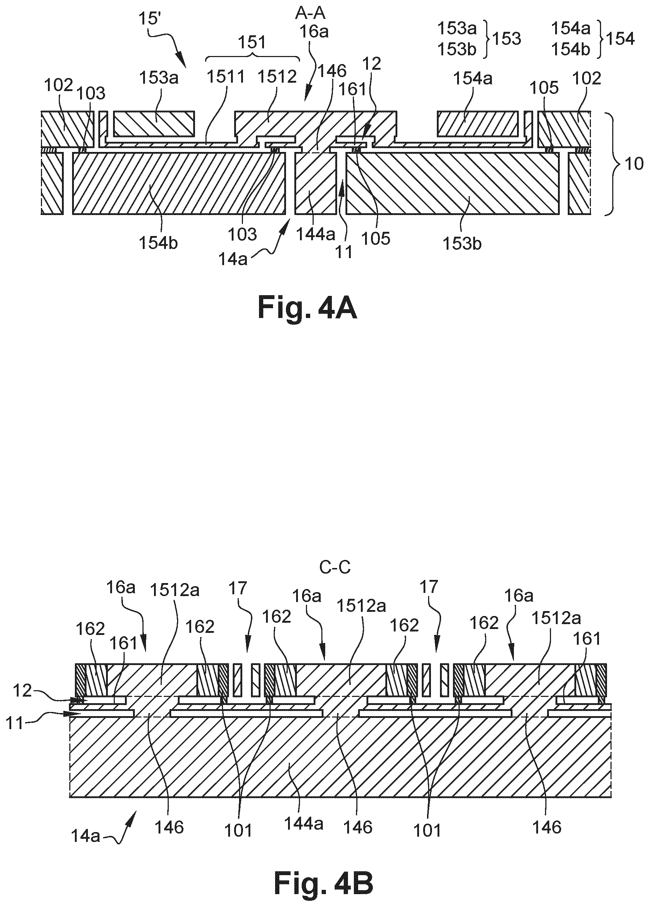

La figure 2 est une vue de dessous du système électromécanique 2 montrant des premières portions 101 du bâti 10, l'élément mobile 13, les dispositifs de transmission 14a-14b et les électrodes mobiles 151-152 des moyens de détection capacitive 15'. La figure 3 est une vue de dessus montrant seulement une partie des moyens de détection capacitive 15' (dont la première électrode mobile 151). Les figures 4A à 4B sont différentes vues de coupe du système électromécanique 2, respectivement selon les plans de coupe A-A et C-C représentés sur la figure 3. Elles représentent en partie le bâti 10, le premier dispositif de transmission 14a et les moyens de détection capacitive 15'.
Le bâti 10 est composé de parties fixes du système électromécanique 2.
L'élément mobile 13, appelé ci-après piston, est ici mobile en translation par rapport au bâti 10, selon une direction (Z) perpendiculairement au plan (XY) de la figure 2. Il comprend de préférence une membrane 131 et une structure de rigidification 132 de la membrane 131, aussi appelée squelette ou armature. La membrane 131 du piston 13 a ici pour rôle de récolter sur toute sa surface une différence de pression entre ses deux faces, pour en déduire une variation de la pression atmosphérique.
La membrane 131 du piston 13 peut délimiter en partie un volume fermé dit de référence, où règne une pression de référence. Elle sépare ce volume de référence d'une cavité ouverte sur l'environnement extérieur. Une face de la membrane 131 est donc soumise à la pression de référence et une face opposée de la membrane 131 est soumise à la pression atmosphérique (dont on souhaite détecter la variation dans le cas d'un microphone). Alternativement, le volume de référence peut être quasi-fermé, au sens où il existe une tranchée autour du piston (qui est détouré). Cette tranchée permet au piston de bouger et autorise une fuite d'air entre le volume de référence et l'extérieur. Cette fuite est faible pour que les pressions puissent s'égaliser lentement, de sorte à filtrer uniquement les variations de pression de basses fréquences.

La première zone 11 englobe la cavité ouverte sur l'environnement extérieur, soumise à la pression atmosphérique, et le volume de référence soumis à la pression de référence.

Les moyens de détection capacitive 15' permettent de mesurer le déplacement du piston 13, et donc la différence de pression entre ses deux faces. Outre les première et deuxième électrodes mobiles 151-152, ils comprennent au moins une électrode fixe (par rapport au bâti 10), séparée de la première électrode mobile 151 par un premier milieu diélectrique, et au moins une électrode fixe additionnelle, séparée de la deuxième électrode mobile 152 par un deuxième milieu diélectrique.

Chaque électrode mobile et électrodes fixe(s) associées forment les armatures d'un ou plusieurs condensateurs dont la capacité varie en fonction du déplacement du piston 13. Les électrodes fixes peuvent être également appelées « contre-électrodes ».

Le premier milieu diélectrique et le deuxième milieu diélectrique ne sont pas solides (mais de préférence constitués par un gaz ou un mélange de gaz), pour ne pas entraver le mouvement des électrodes mobiles 151-152. Le deuxième milieu diélectrique est ici identique au premier milieu diélectrique, car les électrodes mobiles 151-152 sont toutes les deux situées dans la deuxième zone 12.

La deuxième zone 12 est avantageusement une chambre sous atmosphère contrôlée pour réduire les phénomènes de frottement visqueux et les bruits acoustiques associés. Par « chambre sous atmosphère contrôlée », on entend une chambre sous une pression réduite, typiquement inférieure à 1000 mbar, et de préférence inférieure à 1 mbar. Ainsi, la deuxième zone 12 est ici soumise à une pression bien inférieure à la pression atmosphérique ou la pression de référence.

Le premier dispositif de transmission 14a est monté mobile en rotation par rapport au bâti 10, au moyen de plusieurs premières articulations pivot 16a. Il comprend de préférence un premier arbre de de transmission 144a et un ou plusieurs premiers bras de transmission 145a, aussi appelés bras de levier.

Le premier arbre de transmission 144a présente un premier axe longitudinal de rotation Xa (désigné ci-après premier axe Xa), qui s'étend dans une première direction X. Autrement dit, le premier arbre de transmission 144a peut pivoter sur lui-même, autour du premier axe Xa. Il s'étend en regard du piston 13, en regard d'une zone située entre le piston 13 et la première électrode mobile 151 et en regard de la première électrode mobile 151.

La première électrode mobile 151 est avantageusement solidaire du premier arbre de transmission 144a, ce qui signifie qu'il n'y a pas de mouvement relatif entre la première électrode mobile 151 et le premier arbre de transmission 144a. La première électrode mobile 151 est donc également montée mobile en rotation autour du premier axe Xa.

Le système électromécanique 2 est ainsi dépourvu d'organes de transformation du mouvement entre le premier dispositif de transmission 14a et la première électrode mobile 151, tels que des lames de torsion pour passer d'une rotation à une translation. Il en résulte qu'aucune énergie n'est perdue dans ces organes de transformation (par exemple, par déformation des lames de torsion).

Les premiers bras de transmission 145a, par exemple au nombre de trois sur la figure 2, peuvent s'étendre perpendiculairement au premier axe Xa, autrement dit dans une deuxième direction Y perpendiculaire à la première direction X. Les première et deuxième directions X-Y constituent avec une troisième direction Z perpendiculaire un repère orthogonal.

Chaque premier bras de transmission 145a comprend une première extrémité couplée au piston 13 et une deuxième extrémité solidaire du premier arbre de transmission 144a. Un ou plusieurs éléments de couplage 133 relient la structure de rigidification 132 du piston 13 à la première extrémité de chaque premier bras de transmission 145a. Une partie au moins des éléments de couplage 133 (par exemple des lames de torsion) permettent le passage d'un mouvement de translation (piston 13) à un mouvement de rotation (premier arbre de transmission 144a et première électrode mobile 151) tout en couplant fortement leur déplacement selon la troisième direction Z. Ces éléments de couplage 133 sont aptes à se déformer élastiquement.

Le mouvement de translation du piston 13 entraine la rotation des premiers bras de transmission 145a, et donc du premier arbre de transmission 144a, autour du premier axe Xa. Puis, ce mouvement de rotation est transmis à la première électrode mobile 151.

Les premières articulations pivot 16a, par exemple au nombre de six, sont alignées, ici dans la première direction X. De préférence, l'une des premières articulations pivot 16a est située à l'extrémité du premier arbre de transmission 144a, du côté du piston 13 (soit à l'opposé de la première électrode mobile 151), tandis que d'autres premières articulations pivot 16a sont situées du côté de la première électrode mobile 151. Comme il sera décrit en détail par la suite, la première électrode mobile 151 est de préférence reliée au premier arbre de transmission 144a au niveau de ces autres premières articulations pivot 16a.

Le deuxième dispositif de transmission 14b est également monté mobile en rotation par rapport au bâti 10, au moyen de deuxièmes articulations pivot 16b. Il est de préférence construit de la même façon que le premier dispositif de transmission 14a. Plus particulièrement, il comprend un deuxième arbre de transmission 144b présentant un deuxième axe longitudinal de rotation Xb (désigné ci-après deuxième axe Xb) et des deuxièmes bras de transmission 145b (par exemple trois). Chaque deuxième bras de transmission 145b comprend une première extrémité couplée (par l'intermédiaire d'un ou plusieurs éléments de couplage 133) au piston 13 et une deuxième extrémité solidaire du deuxième arbre de transmission 144b. Les deuxièmes bras de transmission 145b s'étendent de préférence perpendiculairement au deuxième axe Xb.

La deuxième électrode mobile 152 est avantageusement solidaire du deuxième arbre de transmission 144b et tourne donc autour du deuxième axe Xb.

Les deuxièmes articulations pivot 16b sont de préférence réparties sur le deuxième axe Xb de la même façon que les premières articulations pivot 16a sont réparties sur le premier axe Xa (l'une d'elles est située à l'extrémité du deuxième arbre de transmission 144b et d'autres sont situées au niveau de la deuxième électrode mobile 152).

Les premiers bras de transmission 145a sont couplés à une première moitié du piston 13 (la moitié supérieure sur la figure 2) et les deuxièmes bras de transmission 145b sont couplés à une deuxième moitié du piston 13 (la moitié inférieure sur la figure 2). Ainsi, les dispositifs de transmission 14a-14b supportent le piston 13 et le maintiennent dans un mouvement de translation. De préférence, le piston 13 est tenu uniquement par les premiers et deuxièmes bras de transmission 145a-145b. Ainsi, une plus grande proportion de l'énergie collectée par le piston 13 est transmise aux électrodes mobiles 151-152.

Comme cela est illustré par la figure 2, le premier axe Xa et le deuxième axe Xb sont avantageusement parallèles. Cela contribue à réduire l'encombrement du système électromécanique 2 et permet de soutenir le piston de manière homogène.

La première électrode mobile 151 et la deuxième électrode mobile 152 peuvent être identiques et disposées de manière symétrique par rapport à un plan P séparant les première et deuxième moitiés du piston 13. Cette symétrie permet d'obtenir une réaction identique sur les deux moitiés du piston pour que celui-ci se maintienne bien en translation.

Le premier dispositif de transmission 14a et le deuxième dispositif de transmission 14b peuvent être également symétriques par rapport au plan P. Le premier arbre de transmission 144a et la première électrode mobile 151 pivotent alors dans un sens (autour du premier axe Xa), alors que le deuxième arbre de transmission 144b et la deuxième électrode mobile 152 pivotent dans le sens inverse (autour du deuxième axe Xb).

Le piston 13 peut également présenter une symétrie par rapport au plan P.

Les symétries du piston 13 et des dispositifs de transmission 14a-14b permettent de répartir l'énergie collectée par le piston 13 équitablement entre la première électrode mobile 151 et la deuxième électrode mobile 152. En effet, la force exercée par le piston 13 est répartie équitablement entre les première et deuxième moitiés, et donc entre les premier et deuxième dispositifs de transmission 14a-14b.

Le montage en rotation de la première électrode mobile 151 et de la deuxième électrode mobile 152, selon respectivement le même axe de rotation que le premier dispositif de transmission 14a et le deuxième dispositif de transmission 14b, permet d'obtenir un plus grand déplacement des électrodes mobiles 151-152 pour un déplacement du piston 13 donné, sans toutefois augmenter l'encombrement du système électromécanique 2. Les électrodes mobiles 151-152 peuvent donc être rapprochées autant que possible du piston 13.

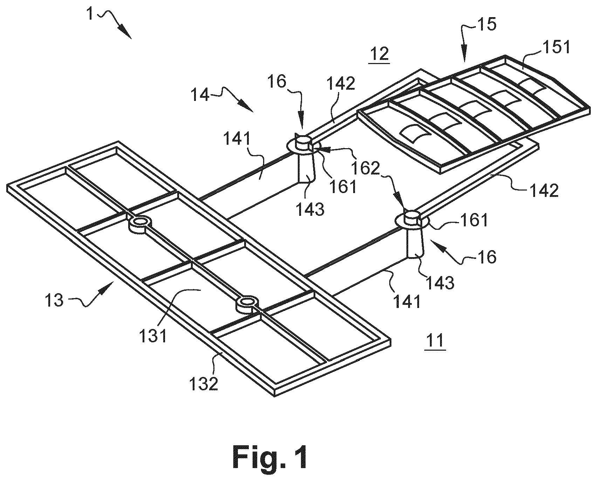

Le passage d'une électrode mobile (Fig.1) à deux électrodes mobiles (Fig.2) n'augmente pas non plus l'encombrement du système électromécanique 2 de manière significative, car les deux électrodes mobiles 151-152 peuvent être disposées en vis-à-vis dans le prolongement du piston 13.

Le déplacement de chaque électrode mobile 151, 152 rapporté à celui du piston 13 est fonction de la distance $L_{pist1}$, $L_{pist2}$ entre la première extrémité des arbres de transmission 145a, 145b et l'axe de rotation Xa, Xb correspondant. Cette distance peut être du même ordre de grandeur que la distance $L_{elec1}$, $L_{elec2}$ entre un bord longitudinal (c'est-à-dire selon X) de l'électrode mobile 151, 152 et l'axe de rotation Xa, Xb.

Plus précisément, le déplacement en Z du bord longitudinal de la première électrode mobile 151 est donné par la relation suivante :

[Math. 1]

$$d_{Zelec1} = \frac{L_{elec1}}{L_{pist1}} \times d_{Zpist}$$

où $d_{Zpist}$ est le déplacement en Z du piston 13 (et donc de toutes les premières extrémités des premiers et deuxièmes bras de transmission 145a-145b), $L_{elec1}$ est la distance entre le bord longitudinal de la première électrode mobile 151 et le premier axe Xa et $L_{pist1}$ est la distance entre la première extrémité de chaque premier bras de transmission 145a et le premier axe Xa.

Le déplacement en Z du bord longitudinal de la deuxième électrode mobile 152 est donné par la relation suivante :

[Math. 2]

$$d_{Zelec2} = \frac{L_{elec2}}{L_{pist2}} \times d_{Zpist}$$

où $L_{elec2}$ est la distance entre le bord longitudinal de la deuxième électrode mobile 152 et le deuxième axe Xb et $L_{pist2}$ est la distance entre la première extrémité de chaque deuxième bras de transmission 14b et le deuxième axe Xb.

Les arbres de transmission 144a-144b et les bras de transmission 145a-145b peuvent être particulièrement rigides, et donc peu sensibles aux déformations qui équivalent à des pertes d'énergie. Cette rigidité des arbres de transmission 144a-144b et des bras de transmission 145a-145b peut notamment être conférée par une épaisseur importante (mesurée dans la troisième direction Z), de préférence comprise entre 5 μm et 800 μm, et plus préférentiellement entre 50 μm et 200 μm. Les arbres de transmission 144a-144b et les bras de transmission 145a-145b sont avantageusement formés par gravure d'un substrat. Ce substrat peut être aminci, jusqu'à une épaisseur inférieure à 200 μm.

Comme les arbres de transmission 144a-144b tournent sur eux-mêmes, leur inertie reste faible et n'impacte pas négativement la fréquence de résonance du système électromécanique 2. Toutefois, ils peuvent être ajourés, comme cela est illustré sur la figure 2, afin d'optimiser leur ratio rigidité sur inertie. Les arbres de transmission 144a-144b sont de préférence ajourés au moins dans la portion située en regard du piston 13. Cela permet en outre de limiter l'amortissement avec le piston 13 (phénomène appelé « squeeze film damping » en anglais), qui est une source de bruit.

La largeur des arbres de transmission 144a-144b (mesurée dans la première direction Y) est du même ordre de grandeur que leur épaisseur, afin de minimiser leur inertie. Elle est avantageusement comprise entre 5 μm et 800 μm.

Les moyens de détection capacitive 15' vont maintenant être décrits plus en détail, en se référant uniquement à la première électrode mobile 151 (connectée au premier dispositif de transmission 14a). Néanmoins, cette description s'applique *mutatis mutandis* à la deuxième électrode mobile 152 (connectée au deuxième dispositif de transmission 14b), étant donné qu'elle peut être identique à la première électrode 151. De même, la description qui sera faite des premières articulations pivot 16a vaut pour les deuxièmes articulations pivot 16b.

En référence aux figures 2 et 3, la première électrode 151 peut comprendre une membrane 1511 et une structure de rigidification 1512 de la membrane 1511. La structure de rigidification 1512 comprend de préférence une pluralité de premières poutres 1512a s'étendant parallèlement les unes aux autres. Elle peut en outre comprendre des deuxièmes poutres 1512b reliant les premières poutres 1512a à leurs extrémités.

Les premières poutres 1512a s'étendent de préférence dans la deuxième direction Y, avantageusement d'un premier bord à un deuxième bord opposé de la première électrode mobile 151. Elles sont avantageusement espacées régulièrement les unes des autres, pour rigidifier la membrane 1511 de manière uniforme. Les deuxièmes poutres 1512b s'étendent de préférence dans la première direction X (donc perpendiculairement aux premières poutres 1512a).

La première électrode mobile 151 présente avantageusement un ou plusieurs plans de symétrie, par exemple un plan parallèle au plan XZ (donc perpendiculaire aux premières poutres 1512a) et un autre plan parallèle au plan YZ.

La structure de rigidification 1512 de la première électrode mobile 151 est avantageusement ancrée, ou fusionnée, au premier dispositif de transmission 14a au niveau d'une partie des premières articulations pivot 16a. Par rapport au microphone 1 de la figure 1, le système électrostatique 2 est donc dépourvu des deuxièmes bras de transmission 142 s'étendant dans la deuxième zone 12.

Plus particulièrement, la structure de rigidification 1512 de la première électrode mobile 151 est reliée au premier dispositif de transmission 14a, et plus particulièrement au premier arbre de transmission 144a, par des piliers 146 visibles sur les figures 4A et 4B. Les piliers 146 du premier dispositif de transmission 14a sont semblables aux arbres de transmission 143 de la figure 1, car ils s'étendent en partie dans la première zone 11 et en partie dans la deuxième zone 12. En effet, l'étanchéité entre la première zone 11 et la deuxième zone 12 s'effectue également au niveau des premières articulations pivot 16a associées à la première électrode mobile 151.

Le premier dispositif de transmission 14a est ainsi réduit à des premiers éléments s'étendant exclusivement dans la première zone 11 (le premier arbre de transmission 144a et les premiers bras de transmission 145a) et à des deuxièmes éléments (les piliers 146) qui s'étendent en partie dans la première zone 11 et en partie dans la deuxième zone 12. Cette réduction du premier dispositif de transmission 14a permet de limiter les pertes d'énergie. Il n'y a notamment plus de pertes par déformation des deuxièmes bras de transmission 142.

Le système électromécanique 2 est particulièrement compact, car plusieurs fonctions, à savoir la mise en rotation du premier dispositif de transmission 14a, l'étanchéité entre les deux zones 11-12 et la connexion à la première électrode mobile 151, sont réalisées au même endroit.

L'ancrage entre la structure de rigidification 1512 et le premier dispositif de transmission 14a est de préférence réalisé au moyen des premières poutres 1512a. Une partie au moins d'entre elles sont fusionnées au premier dispositif de transmission 14a, chacune au niveau d'une première articulation pivot 16a correspondante. Le point d'ancrage de chaque première poutre 1512a se situe avantageusement à la moitié de sa longueur. Ainsi, l'axe de rotation de la première électrode mobile 151 se situe dans un des plans de symétrie de la première électrode mobile 151 (celui perpendiculaire aux première poutres 1512a). La longueur des premières poutres 1512a est mesurée dans la deuxième direction Y, tandis que leur largeur est mesurée dans la première direction X.

Chaque première poutre 1512a fusionnée avec le premier dispositif de transmission 14a présente avantageusement une largeur qui décroit en s'éloignant de la première articulation pivot 16a correspondante.

Dans ce premier mode de réalisation du système électromécanique 2, chacune des premières poutres 1512a de la structure de rigidification 1512 est fusionnée au premier dispositif de transmission 14a. En d'autres termes, à chaque première poutre 1512a est associée une première articulation pivot 16a. Le nombre de premières articulations pivot 16a du côté de la première électrode mobile 151 est donc égal au nombre de première poutres 1512a. Cette disposition permet d'aménager un espace 17 entre deux premières articulations pivot 16a successives.

Le bâti 10 peut comprendre, pour chaque première articulation pivot 16a, deux premières portions 101 distinctes disposées de part et d'autre de la première poutre 1512a associée à la première articulation pivot. La première poutre 1512a est de préférence reliée à chacune des premières portions 101 du bâti 10 par une lame de torsion 162 (cf. Fig.3).

Comme cela est représenté par les figures 3, 4A à 4B, les moyens de détection capacitive 15' comprennent de préférence deux contre-électrodes 153-154 associées à la première électrode mobile 151 : une première contre-électrode 153 dite positive et une deuxième contre-électrode 154 dite négative. Préférentiellement, une partie au moins de la membrane 1511 de la première électrode mobile 151 est située entre les deux contre-électrodes 153-154 (cf. Figs.4A-4B). La première électrode mobile 151 et les contre-électrodes 153-154 forment ainsi les armatures de deux condensateurs dont les capacités varient dans des sens opposés. Une mesure différentielle du déplacement du piston 13 peut être ainsi obtenue. Les surfaces des contre-électrodes 153-154 en regard de la première électrode mobile 151 sont avantageusement identiques, grâce à une symétrie de la première électrode mobile 151 et des contre-électrodes 153-154 par rapport aux premières articulations pivot 16a (le plan de symétrie est confondu avec le plan de coupe C-C).

Avantageusement, chacune des contre-électrodes 153, 154 comprend une première portion 153a, 154a et une deuxième portion 153b, 154b situées de part et d'autre de la membrane 1511 et de part et d'autre des premières articulations pivot 16a. La première portion 153a, 154a, dite supérieure, et la deuxième portion 153b, 154b, dite inférieure, d'une même contre-électrode sont reliées électriquement. Cette disposition permet d'obtenir une mesure totalement différentielle, même si la distance entre la membrane 1511 et les portions supérieures 153a-154a des contre-électrodes (appelée entrefer supérieur) est différente de la distance entre la membrane 1511 et les portions inférieures 153a-154a des contre-électrodes (entrefer inférieur).

Les portions inférieures 153b-154b des contre-électrodes 153-154 s'étendent sous les première poutres 1512a de la structure de rigidification 1512, de chaque côté des premières articulations pivot 16a. En revanche, les portions supérieures 153a-154a des contre-électrodes 153-154 sont de préférence divisées chacune en plusieurs blocs (ou sous-portions) séparées par les premières poutres 1512a, comme cela est illustré par la figure 3. Les portions supérieures 153a-154a des contre-électrodes 153-154 étant inscrites dans la structure de rigidification 1512, leur surface en regard de la membrane 1511 est inférieure à celle des portions inférieures 153b-154b.

En référence à la figure 4A, les portions inférieures 153b-154b des contre-électrodes 153-154 sont de préférence solidarisées à une portion annulaire 102 du bâti 10, située à la périphérie de la première électrode mobile 151, au moyen de joints annulaires 103, 105 en un matériau électriquement isolant (un joint annulaire par portion inférieure 153b, 154b). Ces joints annulaires 103, 105, par exemple en oxyde de silicium, assurent en outre l'étanchéité entre la première zone 11 et la deuxième zone 12.

De façon alternative, les moyens de détection capacitive 15' peuvent comprendre (pour chaque électrode mobile) qu'une seule contre-électrode (inférieure ou supérieure), deux contre-électrodes supérieure et inférieure mais situées d'un seul côté des articulations pivot 16 (détection pseudo-différentielle) ou encore deux contre-électrodes inférieures ou supérieures disposées de part et d'autre des articulations pivot 16 (détection différentielle).

Comme indiqué précédemment, l'étanchéité entre les première et deuxième zones 11-12 du système électromécanique 2 peut être réalisée au niveau des premières articulations pivot 16a situées du côté de la première électrode mobile 151. Comme illustré sur les figures 4A et 4B, chaque première articulation pivot 16a associée à la première électrode mobile 151 comprend un élément d'isolation étanche 161, apte à se déformer élastiquement sous l'effet du déplacement en rotation du premier dispositif de transmission 14a. L'élément d'isolation étanche 161 se présente de préférence sous la forme d'une membrane d'étanchéité.

Chaque élément d'isolation étanche 161 est de préférence traversé par un pilier 146 associé du premier dispositif de transmission 14a. L'élément d'isolation étanche 161 s'étend par exemple depuis le pilier 146 associé jusqu'aux portions inférieures 153b-154b des contre-électrodes 153-154 (cf. Fig.4A) et aux premières portions 101 du bâti 10 (cf. Fig.4B), auxquelles il est ancré grâce aux joints annulaires 103, 105 en matériau électriquement isolant.

En outre, chaque première articulation pivot 16a (associée à la première électrode mobile 151) comprend avantageusement deux lames de torsion 162 (une par première portion 101 du bâti 10). Les lames de torsion 162 sont dimensionnées de sorte à pouvoir se déformer (élastiquement) en torsion et permettre la rotation du premier dispositif de transmission 14a et de la première électrode mobile 151, tout en limitant leurs mouvements de translation, notamment selon la troisième direction Z (translation dite « hors plan »). Les deux lames de torsion 162 relient la structure de rigidification 1512 de la première électrode mobile 151 (fusionnée au pilier 146 du premier dispositif de transmission 14a) aux premières portions 101 du bâti 10 (cf. également Fig.4B). Elles sont de préférence alignées et disposées de façon diamétralement opposée par rapport à la première poutre 1512a associée à la première articulation pivot 16a.

La première articulation pivot 16a située à l'extrémité du premier arbre de transmission 144a comprend avantageusement un élément d'isolation étanche 161 (de préférence sous la forme d'une membrane) et deux lames de torsion 162, mais ne participe pas à l'étanchéité entre les première et deuxième zones 11-12 (étant située uniquement dans la première zone 11).

Le système électromécanique 2 comprend des moyens élastiques reliés à la première électrode mobile 151 et configurés pour générer une force élastique qui s'oppose au mouvement de la première électrode mobile 151. Le rôle de ces moyens élastiques est de lutter contre le phénomène d'effondrement (appelé « pull-in » en anglais) de la première électrode mobile 151. Leur raideur influe sur la tension d'effondrement (ou « pull-in voltage » du système), donc sur la faculté à polariser la première électrode mobile 151.

Les moyens élastiques « anti-pull-in » relient (mécaniquement) la structure de rigidification 1512 de la première électrode mobile 151 au bâti 10 et/ou à des éléments solidaires du bâti, tels que les contre-électrodes 153-154, éventuellement par l'intermédiaire des piliers 146 du premier dispositif de transmission 14a. Ainsi, ne sont pas considérés comme des moyens élastiques « anti-pull-in » la raideur du premier dispositif de transmission 14a ou la raideur de la structure de rigidification 1512 elle-même.

Les moyens élastiques « anti-pull-in » comprennent ici les éléments d'isolation étanches 161 et, le cas échéant, les lames de torsion 162. Les éléments d'isolation étanches 161 et les lames de torsion 162 remplissent ainsi plusieurs fonctions simultanément.

Les moyens élastiques « anti-pull-in » sont reliées à la structure de rigidification 1512 là où elle est la plus rigide, à savoir au niveau des premières articulations pivot 16a. Ainsi, la raideur des moyens élastiques « anti-pull-in » n'est pas dégradée par des éléments en série de raideur trop faible. Cette raideur peut en outre être contrôlée facilement, en jouant sur les dimensions des éléments d'isolation étanches 161 et des lames de torsion 162. Les éléments d'isolation étanches 161 peuvent être délimités par gravure anisotrope d'une couche sacrificielle (par exemple en $SiO_2$) et sont réalisés dans une couche structurelle dont l'épaisseur est maitrisée. Ce type de gravure permet un bon contrôle des dimensions des éléments d'isolation étanches 161. La raideur des éléments d'isolation étanches 161 présente en conséquence une faible dispersion (principalement entre les différents systèmes électromécaniques fabriqués sur une même plaquette ou sur différentes plaquettes).

La deuxième électrode mobile 152 est avantageusement connectée au deuxième dispositif de transmission 14b de la même façon que la première électrode mobile 151 est connectée au premier dispositif de transmission 14a. Ainsi, le système électromécanique 2 comprend également des moyens élastiques « anti-pull-in » reliés à la deuxième électrode mobile 152, ces moyens élastiques comprenant de préférence les éléments d'isolation étanches 161 et, le cas échéant, les lames de torsion 162 des deuxièmes articulations pivot 16b.

Les éléments d'isolation étanches 161 et le cas échéant, les lames de torsion 162, constituent avantageusement les seuls moyens « anti-pull-in » du système électromécanique 2. Ainsi, le système électromécanique 2 est particulièrement compact.

Le système électromécanique 2 décrit ci-dessus peut être fabriqué grâce aux procédés décrits dans les brevets FR3059659B1 et FR3114584B1, notamment en partant d'un empilement de couches comprenant successivement un substrat, une première couche sacrificielle et une première couche structurelle. L'empilement peut notamment être une structure multicouche de type silicium sur isolant ou SOI (« Silicon On Insulator » en anglais), communément appelée substrat SOI.

Le substrat sert notamment à réaliser, par gravure, les premiers éléments des dispositifs de transmission 14a-14b (arbres de transmission 144a-144b et bras de transmission 145a-145b), les portions inférieures 153b-154b des contre-électrodes 153-154 et une partie du bâti 10. Le substrat peut être en un matériau semiconducteur, par exemple le silicium.

La première couche structurelle sert notamment à réaliser la membrane 131 du piston 13, la membrane 1511 des électrodes mobiles 151-152 et les éléments d'isolation étanches 161 (membranes d'étanchéité). Elle présente une épaisseur inférieure à celle du substrat, de préférence comprise entre 100 nm et 10 $\mu$m. Elle est de préférence constituée du même matériau que le substrat, par exemple le silicium.

La première couche sacrificielle a vocation à disparaître en partie lors de la fabrication du système électromécanique 2 pour libérer la membrane 131 du piston 13, la membrane 1511 des électrodes mobiles 151-152 et les éléments d'isolation étanches 161. Son épaisseur définit notamment la distance entre la membrane 1511 et les portions inférieures 153b-154b des contre-électrodes 153-154 (entrefer inférieur). Cette couche sert également de couche d'arrêt lors de la gravure du substrat, de la membrane 152a et de la deuxième couche structurelle (couche dite « MEMS » décrite ultérieurement). Les parties restantes de la première couche sacrificielle forment les joints annulaires 103, 105 et les piliers 104 inférieurs. La première couche sacrificielle peut être constituée d'un matériau diélectrique, de préférence un nitrure de silicium ou un oxyde de silicium, par exemple le dioxyde de silicium ($SiO_2$). Son épaisseur est par exemple comprise entre 100 nm et 10 $\mu$m.

Comme décrit dans les brevets précités, une deuxième couche sacrificielle est déposée sur la première couche structurelle et une deuxième couche structurelle est formée sur la deuxième couche sacrificielle, de préférence par épitaxie.

La deuxième couche structurelle est gravée pour délimiter une partie au moins de la structure de rigidification 132 du piston 13, la structure de rigidification 1512 des électrodes mobiles 151-152, les lames de torsion 162, les portions supérieures 153a-154a des contre-électrodes 153-154, les premières portions 101 et la deuxième portion annulaire 102 du bâti 10. Elle est avantageusement formée du même matériau que la première couche structurelle, par exemple de silicium. L'épaisseur de la deuxième couche structurelle est de préférence comprise entre 5 $\mu$m et 50 $\mu$m.

La structure de rigidification 1512 de chaque électrode mobile 151, 152 est fusionnée au dispositif de transmission 14a, 14b correspondant, en faisant croître la deuxième couche structurelle directement depuis le substrat, à l'emplacement des articulations pivot 16a, 16b (les première et deuxième couche sacrificielles ayant été ouvertes au préalable). Les piliers 146 des dispositifs de transmission 14a, 14b sont formés au cours de cette croissance par épitaxie.

La deuxième couche sacrificielle sert notamment de couche d'arrêt lors de la gravure de la deuxième couche structurelle. Elle est éliminée en partie pour libérer la membrane 131 du piston 13, la membrane 1511 des électrodes mobiles 151-152 et les éléments d'isolation étanches 161. Son épaisseur définit la distance entre la membrane 1511 et les portions supérieures 153a-154a des contre-électrodes 153-154 (entrefer supérieur). La deuxième couche sacrificielle est avantageusement formée du même matériau diélectrique que la première couche sacrificielle, par exemple un oxyde de silicium. Son épaisseur peut être comprise entre 100 nm et 10 $\mu$m.

Ainsi, le bâti 10 comprend une partie formée par le substrat (dans lequel sont également gravés les dispositifs de transmission 14a-14b) et une partie formée par la deuxième couche structurelle. Il comprend en outre un capot rapporté sur la deuxième couche structurelle. Ce capot est ouvert sur l'environnement extérieur pour donner accès au piston 13. Par ailleurs, il ferme la deuxième zone 12 (la chambre sous atmosphère contrôlée) dans laquelle se situent les électrodes mobiles 151-152 des moyens de détection capacitive 15'.

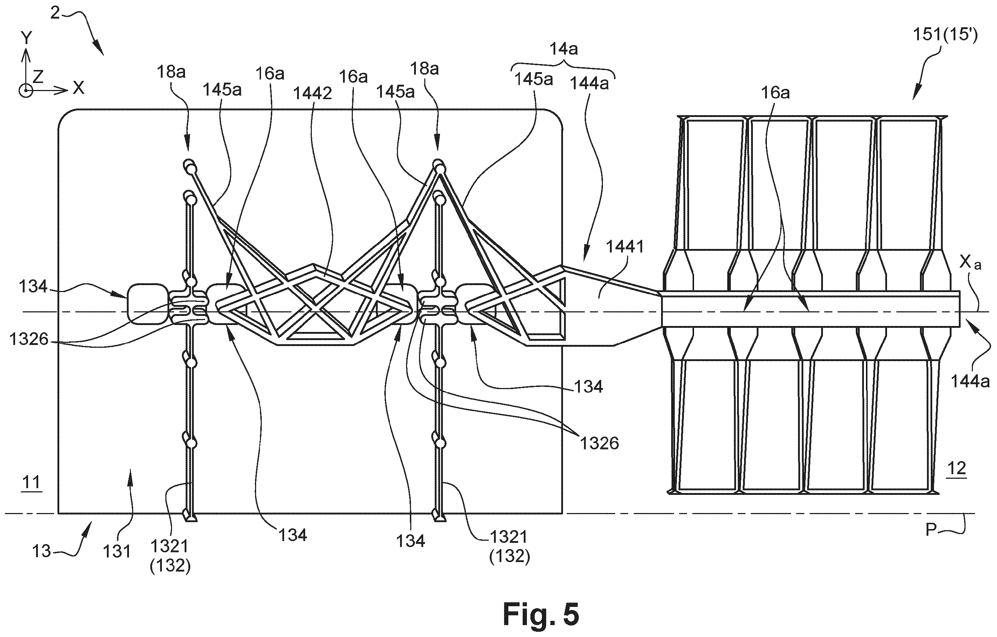

Les figures 5, 6, 7A et 7B représentent schématiquement un deuxième mode de réalisation du système électromécanique 2. Dans ce deuxième mode de réalisation, le bâti 10 et le piston 13 adoptent une configuration particulière permettant aux premier et deuxième dispositifs de transmission 14a-14b d'être plus rigides et plus légers, améliorant ainsi les performances du système électromécanique 2 en termes de sensibilité et de fréquence de résonnance.

Outre le bâti 10, le piston 13 et les dispositifs de transmission 14a-14b, le système électromécanique 2 selon le deuxième mode de réalisation comprend des moyens de détection capacitive 15'. Ces moyens de détection capacitive 15' sont de préférence identiques à ceux du premier mode de réalisation. En particulier, ils comprennent les électrodes mobiles 151-152 qui sont construites et connectées aux dispositifs de transmission 14a-14b de la manière décrite précédemment en relation avec les figures 2, 3 et 4A-4B.

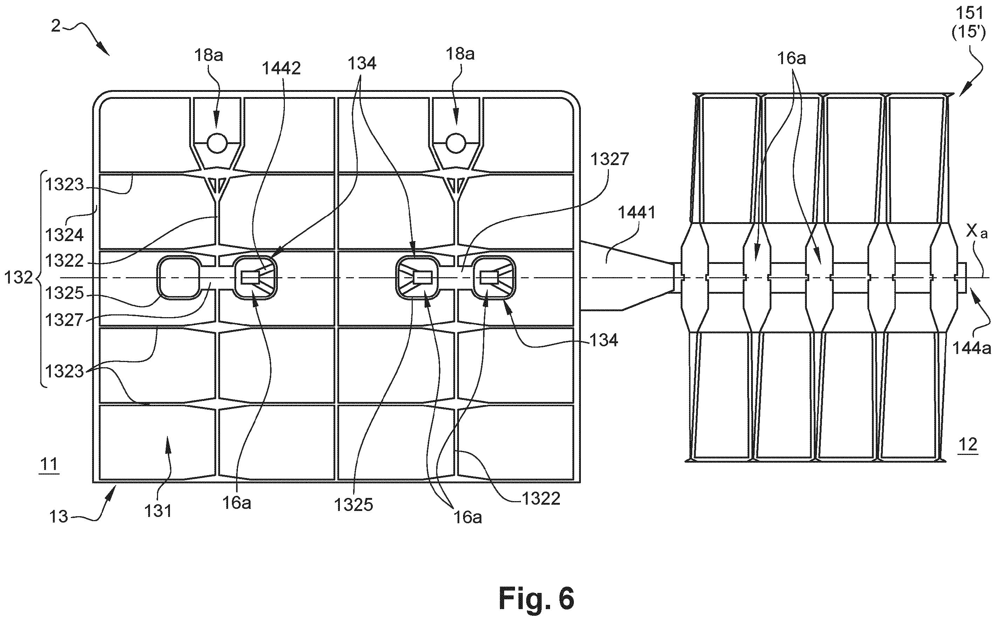

La figure 5 est une vue de dessous, semblable à celle de la figure 2, mais qui ne montre qu'une partie du système électromécanique 2. La figure 6 est une vue de dessus de la même partie du système électromécanique 2. Plus précisément, seule une moitié du piston 13, la première électrode mobile 151 et le premier dispositif de transmission 14a sont représentés sur les figures 5 et 6. Comme précédemment, le piston 13 est avantageusement symétrique par rapport au plan P, de même que les dispositifs de transmission 14a-14b et les électrodes mobiles 151-152.

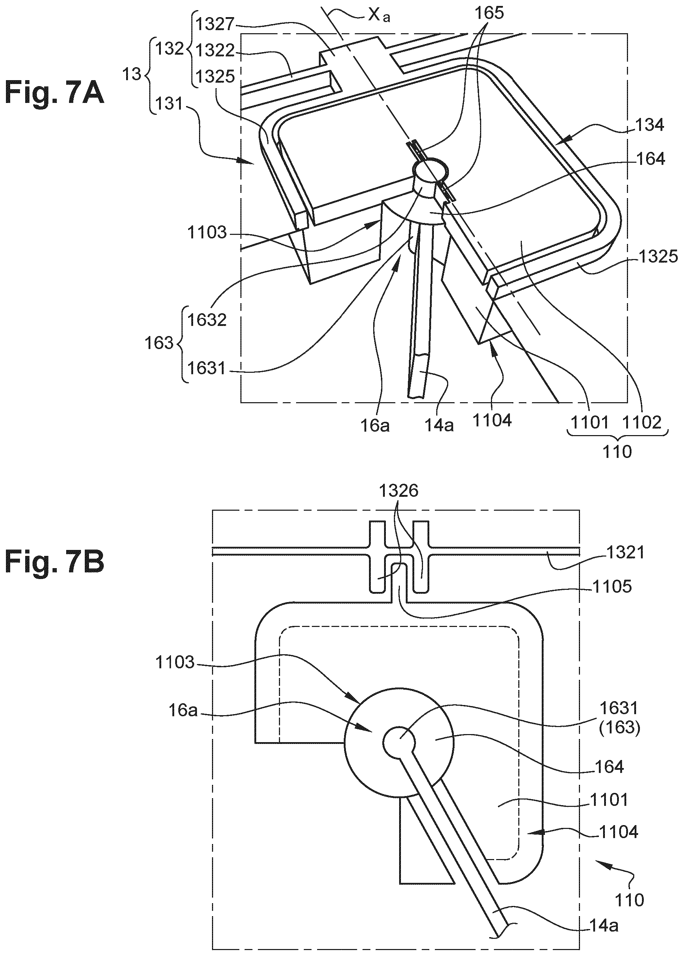

Le système électromécanique 2 des figures 5-6, 7A-7B se distingue de celui de la figure 2 notamment en ce qu'une première ouverture 134 est aménagée dans le piston 13 (cf. Figs.5-6) et en ce que le bâti 10 comprend un premier îlot 110 (visible uniquement sur les figures 7A-7B) qui s'étend à l'intérieur de la première ouverture 134. Le premier dispositif de transmission 14a est relié au premier îlot 110 par l'intermédiaire de l'une des premières articulations pivot 16a.

Comme le premier îlot 110 appartient au bâti 10, il constitue un point fixe dans la zone du piston 13, auquel est relié le premier dispositif de transmission 14a.

Un tel point d'ancrage situé à l'intérieur du périmètre du piston 13 permet au premier dispositif de transmission 14a d'être plus court (comparativement à celui de la figure 2), et donc plus rigide et plus léger. En effet, le premier dispositif de transmission 14a n'a plus besoin de s'étendre jusqu'à la zone périphérique au piston 13, à l'opposé de la première électrode mobile 151.

Le premier îlot 110 améliore donc les performances du système électromécanique 2 en limitant les pertes d'énergie par déformation du premier dispositif de transmission 14a et en diminuant sa masse, quand bien même la surface utile du piston 13 est réduite à cause de la première ouverture 134.

L'une des premières articulations pivot 16a se situe ainsi au niveau de la première ouverture 134, à l'intérieur du périmètre du piston 13. La ou les autres premières articulations pivot 16a peuvent se situer au niveau de la première électrode mobile 151, comme décrit précédemment en relation avec la figure 2.

Comme cela est représenté sur les figures 5 et 6, plusieurs premières ouvertures 134 peuvent être aménagées dans le piston 13. Le bâti 10 comprend alors avantageusement plusieurs premiers îlots 110, chaque premier îlot 110 s'étendant à l'intérieur d'une première ouverture 134, afin de former plusieurs points fixes auxquels est relié le premier dispositif de transmission 14a. Le premier dispositif de transmission 14a est relié à une partie au moins des premiers îlots 110 par l'intermédiaire d'une partie des premières articulations pivot 16a, à raison d'une première articulation pivot 16a par premier îlot 110.

Le nombre de premières ouvertures 134 dans le piston 13 peut être supérieur ou égal au nombre de premier îlots 110. Toutefois, il est de préférence égal au nombre de premiers îlots 110 afin de maximiser la surface utile du piston 13.

Un premier îlot 110 relié au premier dispositif de transmission 14a par l'intermédiaire d'une première articulation pivot 16a est désigné ci-après par l'expression « premier îlot avec charnière ».

En augmentant le nombre de premiers îlots avec charnière, le premier dispositif de transmission 14a est mieux soutenu et encore moins susceptible de se déformer. Les pertes d'énergie par déformation du premier dispositif de transmission 14a sont donc encore plus limitées.

Comme dans le premier mode de réalisation, le premier dispositif de transmission 14a comprend de préférence :

- un premier arbre de transmission 144a, tournant autour de son axe longitudinal Xa ;

- un ou plusieurs premiers bras de transmission (ou bras de levier) 145a ayant chacun une première extrémité solidaire du premier arbre de transmission 144a et une deuxième extrémité couplée au piston 13.

Fournir au moins un point fixe à l'intérieur du périmètre du piston 13 permet en outre de « couper » le premier arbre de transmission 144a en plusieurs portions distinctes, ce qui permet de rigidifier davantage le piston 13 en disposant une partie de la structure de rigidification 132 entre ces portions. En effet, dans le mode de réalisation de la figure 2, le premier arbre de transmission 144a s'étend de manière continue dans la première direction X entre la première électrode mobile 151 et la première articulation pivot 16a située à l'opposé, au-delà du piston 13. La structure de rigidification 132 ne peut donc s'étendre de manière continue dans la deuxième direction Y, du côté du piston 131 où se situe le premier arbre de transmission 144a.

Ici, le premier arbre de transmission 144a comprend avantageusement deux portions distinctes : une première portion 1441 qui s'étend jusqu'aux moyens de détection capacitive 15' et une deuxième portion 1442 reliée à un ou plusieurs premiers îlots 110.

La structure de rigidification 132 du piston 13 comprend avantageusement, du côté de la membrane 131 où se situe le premier arbre de transmission 144a, deux premières poutres 1321, dont une est disposée entre les première et deuxième portions 1441-1442 du premier arbre de transmission 144a. Les deux premières poutres 1321 sont de préférence parallèles entre elles. Elles s'étendent ici dans une direction perpendiculaire au premier axe Xa, autrement dit dans la deuxième direction Y.

La direction des premières poutres 1321 correspond ici à la direction dans laquelle est mesurée la longueur du piston, soit sa plus grande dimension.

Les premières poutres 1321 présentent avantageusement la même épaisseur que le premier arbre de transmission 144a et les premiers bras de transmission 145a, soit une épaisseur comprise entre 5 $\mu$m et 800 $\mu$m, de préférence entre 50 $\mu$m et 200 $\mu$m. Elle est formée en même temps que le premier arbre de transmission 144a et les premiers bras de transmission 145a, par gravure du substrat.

Grâce à leur épaisseur importante, les premières poutres 1321 contribuent grandement à rigidifier le piston 13 (ici dans le sens de sa longueur) et donc à réduire la déformation du piston 13. Elles sont par conséquent à l'origine d'un important gain de performances réparti entre sensibilité et/ou fréquence de résonance.

Chacune des premières poutres 1321 s'étend de préférence sur plus de 50 % de la dimension du piston 13 mesurée dans la deuxième direction Y.

Le fait que les premières poutres 1321 puissent traverser le premier dispositif de transmission 14a augmente considérablement la rigidité du piston 13 et/ou permet d'alléger sa structure de rigidification 132 par ailleurs. Ainsi, une amélioration des performances est également obtenue par l'optimisation de la structure de rigidification 132.

De préférence, du côté de la membrane 131 où se situe le premier arbre de transmission 144a, la structure de rigidification 132 ne comprend que les premières poutres 1321.

De l'autre côté de la membrane 131, représenté par la figure 6, la structure de rigidification 132 du piston 13 comprend avantageusement deux deuxièmes poutres 1322 superposées aux premières poutres 1321. Ces deuxièmes poutres 1322 présentent une épaisseur strictement inférieure à celle des premières poutres 1321. Elles peuvent être formées dans la deuxième couche structurelle décrite précédemment et dont l'épaisseur est comprise entre 5 $\mu$m et 50 $\mu$m. Chaque deuxième poutre 1322 peut avoir une longueur égale à celle de la première poutre 1321 à laquelle elle est associée (ou superposée).

Chaque deuxième poutre 1322 prolonge ainsi une partie au moins de la première poutre 1321 associée dans la troisième direction Z pour atteindre une épaisseur plus importante. Les deuxièmes poutres 1322 augmentent que légèrement la masse du piston 13 (dans une moindre mesure que les premières poutres 1321, grâce à son épaisseur plus faible), mais augmentent considérablement la rigidité du piston (car celle-ci varie en fonction de l'épaisseur au cube).

Du même côté que les deuxièmes poutres 1322, la structure de rigidification 132 peut comprendre en outre des arêtes 1323 orientées perpendiculairement aux premières poutres 1321 (donc de préférence parallèlement au premier axe Xa). Ces arêtes 1323 rigidifient le piston 13 dans sa dimension selon X (ici sa largeur). Les arêtes 1323 n'ont pas besoin d'être épaisses (à la différence des premières poutres 1321), car les connexions avec le premier dispositif de transmission 14a (premières articulations 18a) contribuent également à rigidifier le piston 13 selon X. Les arêtes 1323 ont de préférence la même épaisseur que les deuxièmes poutres 1322 (entre 5 $\mu$m et 50 $\mu$m). Ainsi, elles n'augmentent pas la masse du piston 13 de manière significative. Elles sont également formées par gravure de la deuxième couche structurelle. Elles peuvent s'étendre d'un bord à l'autre du piston 13.

Une partie au moins des arêtes 1323 peuvent venir en appui contre des éléments de butée appartenant au bâti du système électromécanique 2. Ces éléments de butée, par exemple en forme de poutre s'étendant en regard des arêtes 1323, sont prévus pour empêcher la destruction du piston 13 et des électrodes mobiles 151-152, lorsque le piston 13 est soumis à une très grande différence de pression (comme lors des tests de fiabilité).

La structure de rigidification 132 peut comprendre en outre un cadre 1324 situé à la périphérie du piston 13. Ce cadre 1324 a de préférence la même épaisseur que les deuxièmes poutres 1322. Il peut être également formé par gravure de la deuxième couche structurelle.

Enfin, pour chaque première ouverture 134 dans la membrane 131 du piston 13, la structure de rigidification 132 peut comprendre un anneau 1325 autour de la première ouverture 134 et formant un rebord. Cet anneau 1325 a de préférence la même épaisseur que les deuxièmes poutres 1322. Il peut être également formé par gravure de la deuxième couche structurelle.

Dans l'exemple des figures 5 et 6, la deuxième portion 1442 du premier arbre de transmission 144a est située entre les deux premières poutres 1321. Elle est maintenue en rotation par deux premières articulations pivot 16a reliées chacune à un premier îlot 110. Les premières articulations pivot 16a sont de préférence situées aux extrémités de la deuxième portion 1442.

La première portion 1441 du premier arbre de transmission 144a est maintenue en rotation par plusieurs premières articulations pivot 16a situées au niveau de la première électrode mobile 151, et avantageusement, par une première articulation pivot 16a supplémentaire située dans la zone du piston 13 (et donc reliée à un premier îlot 110). Cette première articulation pivot 16a supplémentaire est de préférence située à une extrémité de la première portion 1441 (extrémité la plus éloignée des moyens de détection capacitive 15').

Par ailleurs, le piston 13 est connecté au premier dispositif de transmission 14a au moyen de deux premières articulations 18a. Ces premières articulations 18a sont de préférence situées dans le prolongement des premières poutres 1321. Le premier dispositif de transmission 14a comprend alors plusieurs premiers bras de transmission 145a qui s'étendent depuis le premier arbre de transmission 144a jusqu'à l'une ou l'autre des premières articulations 18a. Prévoir plusieurs premiers bras de transmission 145a limite la torsion du premier dispositif de transmission 14a.

Le premier dispositif de transmission 14a comprend notamment deux premier bras de transmission 145a qui convergeant vers une même première articulation 18a. L'un de ces deux premiers bras de transmission 145a s'étend depuis la première portion 1441 du premier arbre de transmission 144a et l'autre s'étend depuis la deuxième portion 1442 du premier arbre de transmission 144a.

Prévoir plusieurs premières articulations 18a entre le piston 13 et le premier dispositif de transmission 14a (et donc plusieurs premiers bras de transmission 145a) permet de maintenir plus facilement le piston 13 dans un plan parallèle au plan XY et de mieux répartir les efforts, notamment dans le cas d'un piston 13 de grandes dimensions.

Comme le piston 13 est couplé au premier dispositif de transmission 14a en plusieurs endroits (ici deux), il peut être considéré que le piston 13 est composé de plusieurs parties (ici deux) disposées côte à côte dans la première direction X et renforcées chacune par une première poutre 1321. La rigidité en X du piston 13 peut donc être appréciée sur une partie seulement du piston. Avantageusement, la dimension en X de chaque partie du piston est inférieure à la dimension en Y du piston entier. Cependant, la dimension en X du piston entier peut être supérieure à sa dimension en Y (soit longueur en X et largeur en Y).

Pour un piston de surface réduite, la structure de rigidification 132 peut ne comprendre qu'une seule première poutre 1321 disposée entre les deux portions du premier arbre de transmission 144a. Cette première poutre 1321 est avantageusement surmontée d'une unique deuxième poutre 1322. Par ailleurs, le système électromécanique 2 peut ne comprendre qu'une seule première articulation 18a entre le piston 13 et le premier dispositif de transmission 14a, de préférence située dans le prolongement de l'unique première poutre 1321.

A l'inverse, pour un piston de surface plus importante, le premier arbre de transmission 144a peut comprendre plus de deux portions distinctes. Les portions autres que celle qui s'étend jusqu'aux moyens de détection capacitive 15' sont maintenues en rotation grâce à un ou plusieurs (de préférence deux) premiers îlots 110 chacune. Par ailleurs, la structure de rigidification 132 peut comprendre plus de deux premières poutres 1321 (avantageusement disposées en parallèle).

Les figures 7A-7B représentent un exemple de réalisation de premier îlot 110, relié au premier dispositif de transmission 14a par l'intermédiaire d'une première articulation pivot 16a.

Dans cet exemple, le premier îlot 110 comprend une première partie 1101 formée par gravure du substrat et une deuxième partie 1102 formée par gravure de la deuxième couche structurelle.

Une cavité 1103 est aménagée à l'intérieur du premier îlot 110. La première articulation pivot 16a est située dans cette cavité 1103.

La première articulation pivot 16a associée au premier îlot 110 comprend de préférence un pilier 163, une membrane 164 et des lames de torsion 165. Le pilier 163 est solidaire du premier dispositif de transmission 14a et libre de se déplacer en rotation autour du premier axe Xa à l'intérieur du premier îlot 110. Il s'étend dans la troisième direction Z d'un côté à l'autre de la membrane 131 du piston 13. Une première partie 1631 du pilier 163, située du même côté de la membrane que le premier dispositif de transmission 14a, est obtenue par la gravure du substrat. Une deuxième partie 1632 du pilier 163, située du côté opposé de la membrane, est obtenue par la gravure de la deuxième couche structurelle.

La membrane 164 relie le pilier 163 (entre ses première et deuxième parties) au premier îlot 110. Elle est configurée pour se déformer élastiquement sous l'effet du déplacement en rotation du premier dispositif de transmission 14a et pour s'opposer aux mouvements du premier dispositif de transmission 14a dans une première direction. Elle est formée dans la première couche structurelle (comme la membrane 131 du piston 13).

Les lames de torsion 165, par exemple au nombre de deux, relient également le pilier 163 au premier îlot 110. Plus particulièrement, elles relient la deuxième partie 1632 du pilier 163 à la deuxième partie 1102 du premier îlot 110. Elles sont formées par la gravure de la deuxième couche structurelle.

Les lames de torsion 165 sont dimensionnées de sorte à pouvoir se déformer (élastiquement) en torsion et permettre la rotation du dispositif de transmission 14a, tout en limitant ses mouvements de translation selon la troisième direction Z. Elles sont de préférence alignées et disposées de part et d'autre du pilier 163.

De manière avantageuse, une portion 1104 du premier îlot 110 est configurée pour former une butée permettant de limiter le déplacement du piston. Cette portion 1104 du premier îlot 110 est située en regard du piston 13. Ainsi, le piston 13 peut se poser sur la portion 1104 du premier îlot 110 lorsque qu'il est soumis à une très grande différence de pression (comme lors des tests de fiabilité). Une telle butée vise à empêcher la dégradation du piston 13.

Dans l'exemple de réalisation des figures 7A-7B, la butée est formée par une portion périphérique du premier îlot 110, et plus particulièrement une portion périphérique de la première partie 1101. Cette portion périphérique dépasse de la deuxième partie 1102.

En outre, le premier îlot 110 peut comprendre un doigt 1105 configuré pour servir d'appui au piston 13 entre deux doigts 1326 de la structure de rigidification 132 (cf. Fig.5 & Fig.7B). Le doigt 1105 s'étend de préférence depuis la portion périphérique 1104 du premier îlot 110.

Les doigts 1326 de la structure de rigidification 132 s'étendent de préférence depuis une première poutre 1321. Ainsi, le doigt 1105 du premier îlot 110 sert de butée et soulage le piston à un endroit où il est le plus rigide (au voisinage d'une première poutre 1321). De l'autre côté de la membrane 131, la structure de rigidification 132 comprend une portion 1327 qui s'étend au-dessus des doigts 1326 mais également au-dessus de l'espace entre les doigts 1326 (cf. Fig.7A).

Un premier îlot 110 dont une portion forme une butée pour le piston 13 est désigné ci-après par l'expression « premier îlot avec butée ».

Un premier îlot avec butée (avec ou sans charnière) permet de reprendre les efforts à l'intérieur de la zone du piston à distance des bords et de limiter les contraintes mécaniques dans le système électromécanique 2.

De préférence, le bâti 10 comprend au moins deux premiers îlots avec butée. Ces premiers îlots peuvent être ceux qui maintiennent en rotation la deuxième portion 1442 du premier arbre de transmission 144a. Ce sont alors des premiers îlots avec butée et charnière.

Le premier îlot 110 auquel est relié la première portion 1441 du premier arbre de transmission 144a est avantageusement un îlot avec butée et charnière. Ainsi, le bâti 10 comprend deux premiers îlots avec butée et charnière disposés de part et d'autre de la première poutre 1321 qui sépare les deux portions du premier arbre de transmission 144a.

Ainsi, dans l'exemple des figures 5 et 6, le piston 13 comprend trois premières ouvertures 134 accueillant chacune un premier îlot avec charnière et butée.

Une première ouverture 134 additionnelle accueillant un premier îlot avec butée mais sans charnière peut être aménagée dans le piston 13.

Les premiers îlots avec butée (avec ou sans charnière) sont de préférence disposés deux à deux de manière symétrique par rapport à une première poutre 1321. Ils sont avantageusement équipés chacun d'un doigt 1105 se logeant entre deux doigts 1326 de la structure de rigidification 132.

Une solution pour amener les premiers îlots 110 à l'intérieur du périmètre du piston 13 consiste à utiliser le capot qui donne accès au piston.

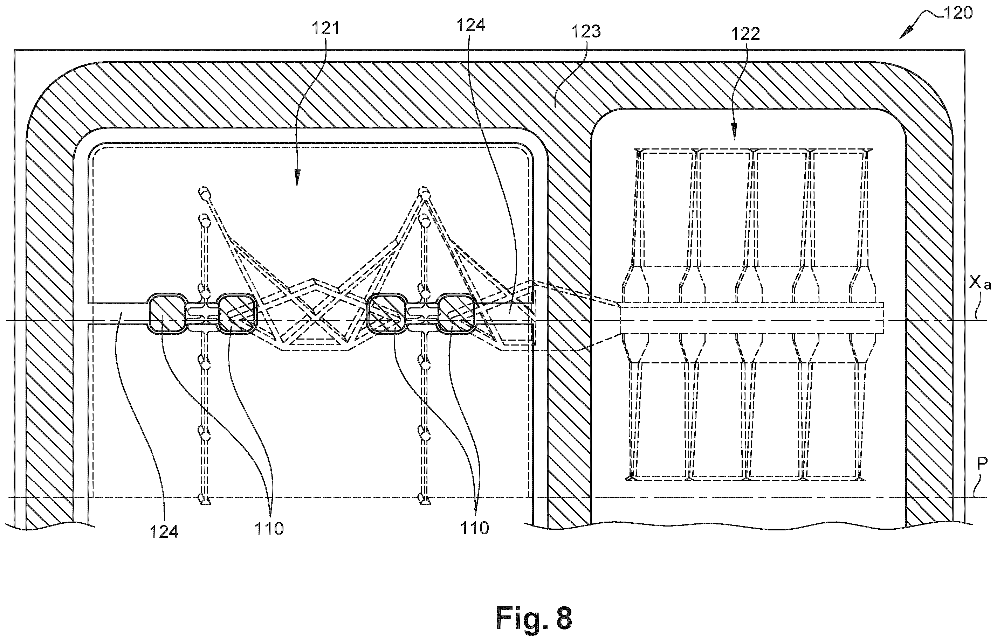

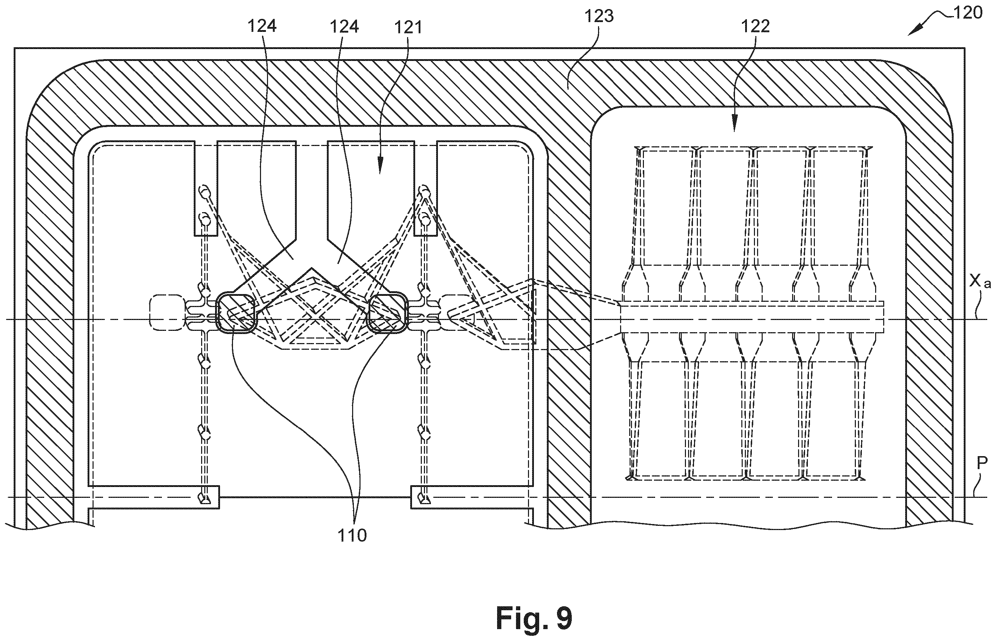

Les figures 8 et 9 représentent deux exemples de capot 120. Le capot 120 est de préférence réalisé par usinage ou gravure d'un deuxième substrat (par exemple en silicium).

D'une manière commune à ces deux exemples, le capot 120 comprend une ouverture 121 pour exposer une face du piston à l'environnement extérieur. Cette ouverture 121 est de préférence dimensionnée pour exposer toute la face du piston. L'ouverture 121 sert de port acoustique.

En outre, le capot 120 comprend au moins une cavité 122, qui constitue une partie de la deuxième zone (chambre à atmosphère contrôlée) dans laquelle se situent les électrodes mobiles des moyens de détection capacitive. La cavité 122 est creusée dans le deuxième substrat.

L'ouverture 121 et la cavité 122 sont entourées par une zone de scellement 123, permettant de fixer le capot 120 au reste du bâti, et plus particulièrement à la deuxième couche structurelle. La zone de scellement 123 assure notamment l'étanchéité de la deuxième zone.

Enfin, le capot 120 comprend au moins un premier bras 124 qui s'étend dans l'ouverture 121. A ce premier bras 124 est fixé un ou plusieurs premiers îlots 110. Comme cela est représenté sur les figures, le capot 120 peut comprendre plusieurs premiers bras 124, s'étendant depuis un même bord de l'ouverture 121 ou depuis des bords différents, afin de fixer tous les premiers îlots 110.

Chaque premier îlot 110 est de préférence fixé à un premier bras 124 de la même façon que le capot 120 est fixé au reste du bâti 10 dans la zone de scellement 123, par exemple par collage direct (par exemple Si-Si) ou par scellement eutectique (par exemple Au-Si ou Al-Ge).

Dans l'exemple de la figure 8, convenant à la configuration des premiers îlots représentée par les figures 5 et 6, le capot 120 comprend deux bras 124 permettant de fixer chacun deux premiers îlots 110. Les bras 124 s'étendent parallèlement au premier axe Xa depuis des bords opposés de l'ouverture 121.

Dans l'exemple de la figure 9, convenant à une configuration à seulement deux premiers îlots 110 (tels que ceux soutenant la deuxième portion 1442 du premier arbre de transmission 144a), le capot 120 comprend deux bras 124 permettant de fixer chacun un premier îlot 110. Les bras 124 s'étendent de préférence depuis un même bord de l'ouverture 121, ici le bord supérieur. Les deux bras 124 peuvent être accolés au départ du bord, puis divergents.

La description qui vient d'être faite en relation avec les figures 5-6, 7A-7B, 8 et 9 est transposable à la deuxième moitié du piston 13 et au deuxième dispositif de transmission 14b, non représentés sur ces figures. Ainsi, une ou plusieurs deuxièmes ouvertures sont aménagées dans la deuxième moitié du piston, le bâti 10 comprend un ou plusieurs deuxièmes îlots, le deuxième dispositif de transmission 14b est relié à un ou plusieurs deuxièmes îlots par une ou plusieurs deuxièmes articulations pivot 16b.

En outre, à titre indicatif et nullement limitatif, les premières poutres 1321 peuvent s'étendre dans la deuxième moitié du piston 13, le deuxième dispositif de transmission 14b peut comprendre un deuxième arbre de transmission 144b découpé en plusieurs portions distinctes, ces portions étant avantageusement séparées deux à deux par une première poutre 1321, le deuxième dispositif de transmission 14b peut être connecté au piston 13 par deux deuxièmes articulations, le capot 120 peut comprendre un ou plusieurs deuxièmes bras s'étendant dans l'ouverture 121 jusqu'au(x) deuxième(s) îlot(s)...

Chaque deuxième îlot est de préférence construit de la même façon que le premier îlot 110 (par exemple de la façon décrite en relation avec les figures 7A-7B).

On rappelle que le piston 13 (et notamment sa structure de rigidification 132), ainsi que les dispositifs de transmission 14a-14b, sont avantageusement symétriques par rapport au plan P. Le capot 120 est également avantageusement symétrique par rapport au plan P.

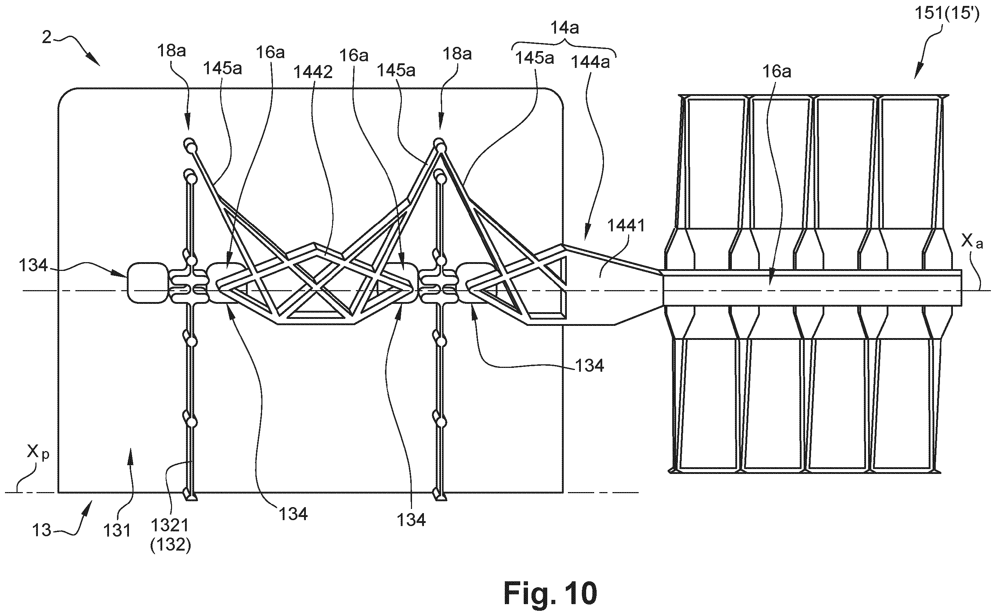

Le système électromécanique 2 ne comprend pas nécessairement les deux électrodes mobiles 151-152 et les deux dispositifs de transmission 154a-154b. Il peut comprendre une unique électrode mobile et un unique dispositif de transmission (cf. Fig.10).

La figure 10 représente un troisième mode de réalisation dans lequel le système électromécanique 2 comprend une unique électrode mobile 151 (par exemple de type représenté par la figure 5) et un unique dispositif de transmission 14a (par exemple de type représenté par la figure 5).

Le piston 13 est ici mobile en rotation autour d'un axe Xp (et non en translation), grâce à des articulations pivot ou charnières (non représentées) distinctes des (premières) articulations pivot 16a. Le mouvement de rotation du piston 13 (autour de l'axe Xp) entraîne en rotation l'arbre de transmission 144a du dispositif de transmission 14a (autour de son propre axe Xa), par l'intermédiaire des bras de transmission 145a et l'arbre de transmission 144a met en mouvement l'électrode mobile 151 (ici en rotation autour de l'axe Xa).

Le système électromécanique 2 n'est pas limité aux modes de réalisation décrits en relation avec les figures 2 à 10 et de nombreuses variantes et modifications du système électromécanique apparaitront à l'homme du métier.

En particulier, les dispositifs de transmission 14a-14b, et plus particulièrement les arbres de transmission 144a-144b, peuvent adopter d'autres géométries. Ils peuvent notamment être continus tout en étant reliés à des îlots dans la zone du piston.

Le système électromécanique 2 des figures 5-6 et 10 peut ne comporter que deux articulations pivot par dispositif de transmission 14a, 14b, par exemple une au niveau de l'électrode mobile 151, 152 et une autre à l'extrémité opposée de l'arbre de transmission 144a, 144b, cette autre articulation pivot étant reliée à un îlot dans la zone du piston 13.

Le système électromécanique 2 a été décrit en prenant pour exemple un microphone à détection capacitive comprenant un piston 13 doté d'une membrane 131 soumise d'une part à la pression atmosphérique et d'autre part à une pression de référence. Le système électromécanique peut cependant former d'autres types de transducteur à détection capacitive, notamment un haut-parleur (émetteur sonore) ou un émetteur ultrasonore (qui sont des transducteurs électroacoustiques), ou encore un capteur de pression différentielle.

Dans le cas d'un capteur de pression différentielle, la première face de la membrane 131 est soumise à une première pression (pas nécessairement la pression atmosphérique) et la deuxième face de la membrane 131 est soumise à une deuxième pression, différente de la première pression. Le déplacement de la membrane 131, sous l'effet de la différence de pression, est mesuré par les moyens de détection capacitive 15'. La membrane 131 du piston est solidaire du bâti 10 de manière à être étanche et la structure de rigidification 132 du piston est absente ou réduite pour ne pas l'ancrer au bâti.

Dans le cas d'un haut-parleur ou d'un émetteur ultrasonore, des moyens d'actionnement capacitif remplacent les moyens de détection capacitive 15'. Ces moyens d'actionnement capacitif comprennent également deux électrodes mobiles et au moins une contre-électrode par électrode mobile. Les électrodes mobiles sont mises en mouvement par une force électrostatique et ce mouvement est transmis par les dispositifs de transmission 14a, 14b jusqu'au piston 13. Le mouvement de la membrane 131 du piston 13 permet d'émettre un son (ou des ultrasons).

La deuxième zone 12 peut comprendre deux chambres sous atmosphère contrôlée, l'une renfermant la première électrode mobile 151, l'autre renfermant la deuxième électrode mobile 152.

Les première et deuxième zones 11-12 isolées de manière étanche ne sont pas nécessairement soumises à des pressions différentes. La première zone 11 peut aussi être un environnement agressif et les électrodes mobiles des moyens capacitifs (de détection ou d'actionnement) sont placées dans la deuxième zone 12 pour les protéger de cette environnement agressif (en plus de réduire les frottements visqueux, et donc les bruits acoustiques).

Le système électromécanique 2 peut même être dépourvu de moyens d'étanchéité entre les première et deuxième zones 11-12 (ce qui revient à ne considérer qu'une seule zone). Plus particulièrement, les articulations pivot 16 situées au niveau des électrodes peuvent être dépourvues d'élément d'isolation étanche 161. En effet, les lames de torsion 162 peuvent suffire pour la rotation du dispositif de transmission 14a, 14b et comme moyens élastiques « anti-pull-in ».

**Revendications**

1. Système électromécanique (2) comprenant :

   - un bâti (10) ;
   - un élément mobile (13) par rapport au bâti (10), l'élément mobile comprenant une membrane (131) et une structure de rigidification (132) de la membrane ;
   - des moyens capacitifs de mesure ou d'actionnement (15') ;
   - un premier dispositif de transmission (14a) d'un mouvement entre l'élément mobile (13) et les moyens capacitifs de mesure ou d'actionnement (15'), le premier dispositif de transmission (14a) étant mobile en rotation par rapport au bâti (10) au moyen d'une pluralité de premières articulations pivot (16a) ;

   **caractérisé en ce que** :

   - une première ouverture (134) est aménagée dans l'élément mobile (13) ;
   - le bâti (10) comprend un premier îlot (110) s'étendant à l'intérieur de la première ouverture (134) ; et
   - le premier dispositif de transmission (14a) est relié au premier îlot (110) par l'intermédiaire de l'une des premières articulations pivot (16a).

2. Système (2) selon la revendication 1, dans lequel une portion (1104) du premier îlot (110) forme une butée permettant de limiter un déplacement de l'élément mobile (13).

3. Système (2) selon la revendication 2, dans lequel :

   - la structure de rigidification (132) de l'élément mobile (13) comprend deux doigts (1326) ; et
   - le premier îlot (110) comprend un doigt (1105) configuré pour venir en appui contre la membrane (131) de l'élément mobile (13) entre les deux doigts (1326) de la structure de rigidification (132).

4. Système (2) selon l'une quelconque des revendications 1 à 3, dans lequel le premier dispositif de transmission (14a) comprend :

- un premier arbre de transmission (144a) présentant un premier axe longitudinal de rotation (Xa) ;
- au moins un premier bras de transmission (145a) comprenant une première extrémité couplée à l'élément mobile (13) et une deuxième extrémité solidaire du premier arbre de transmission (144a).

5. Système (2) selon la revendication 4, dans lequel le premier arbre de transmission (144a) comprend une première portion (1441) qui s'étend jusqu'aux moyens capacitifs de mesure ou d'actionnement (15') et une deuxième portion (1442) reliée au premier îlot (110), les première et deuxième portions (1441, 1442) du premier arbre de transmission (144a) étant distinctes.

6. Système (2) selon la revendication 5, comprenant une première articulation (18a) entre l'élément mobile (13) et le premier dispositif de transmission (14a) et dans lequel le premier dispositif de transmission (14a) comprend deux premiers bras de transmission (145a) convergeant vers la première articulation (18a), l'un des deux premiers bras de transmission (145a) s'étendant depuis la première portion (1441) du premier arbre de transmission (144a) et l'autre des deux premiers bras de transmission (145a) s'étendant depuis la deuxième portion (1442) du premier arbre de transmission (144a).

7. Système (2) selon l'une des revendications 5 et 6, dans lequel :

   - le premier arbre de transmission (144a) est situé d'un premier côté de la membrane (131) de l'élément mobile (13) ;
   - la structure de rigidification (132) de l'élément mobile (13) comprend une première poutre (1321) située du premier côté de la membrane (131) ; et
   - les première et deuxième portions (1441, 1442) du premier arbre de transmission (144a) sont séparées par la première poutre (1321).

8. Système (2) selon la revendication 7, dans lequel la première poutre (1321) s'étend dans une direction perpendiculaire au premier axe longitudinal de rotation (Xa) et présente une longueur supérieure ou égale à 50 % de la dimension de l'élément mobile (13) mesurée dans ladite direction.

9. Système (2) selon l'une des revendications 7 et 8, dans lequel :

   - la structure de rigidification (132) de l'élément mobile (13) comprend deux premières poutres (1321) situées du premier côté de la membrane (131) et s'étendant en parallèle l'une de l'autre ; et
   - la deuxième portion (1442) du premier arbre de transmission (144a) est située entre les deux premières poutres (1321).

10. Système (2) selon l'une quelconque des revendications 7 à 9, dans lequel la structure de rigidification (132) de l'élément mobile (13) comprend en outre une deuxième poutre (1322) située d'un deuxième côté opposé de la membrane (131) et superposée à la première poutre (1321).

11. Système (2) selon l'une quelconque des revendications 7 à 10, dans lequel la structure de rigidification (132) de l'élément mobile (13) comprend en outre des arêtes (1323) situées d'un deuxième côté opposé de la membrane (131) et s'étendant perpendiculairement à la première poutre (1321).

12. Système (2) selon l'une quelconque des revendications 1 à 11, dans lequel le bâti (10) comprend un capot (120) muni d'une ouverture (121) pour donner accès à l'élément mobile (13) et dans lequel le capot (120) comprend un premier bras (124) s'étendant dans l'ouverture (121) jusqu'au premier îlot (110).

13. Système (2) selon l'une quelconque des revendications 1 à 12, dans lequel :

   - plusieurs premières ouvertures (134) sont aménagées dans l'élément mobile (13) ;
   - le bâti (10) comprend plusieurs premiers îlots (110), chaque premier îlot s'étendant à l'intérieur de l'une des premières ouvertures (134) ; et
   - le premier dispositif de transmission (14a) est relié à une partie au moins des premiers îlots (110) par l'intermédiaire d'une partie des premières articulations pivot (16a).

14. Système (2) selon l'une quelconque des revendications 1 à 13, comprenant en outre un deuxième dispositif de transmission (14b) de mouvement entre l'élément mobile (13) et les moyens capacitifs de mesure ou d'actionnement (15'), le deuxième dispositif de transmission (14b) étant mobile en rotation par rapport au bâti (10) au moyen d'une pluralité de deuxièmes articulations pivot (16b) ; et dans lequel :

- une deuxième ouverture est aménagée dans l'élément mobile (13) ;
- le bâti (10) comprend un deuxième îlot s'étendant à l'intérieur de la deuxième ouverture ; et
- le deuxième dispositif de transmission de mouvement (14b) est relié au deuxième îlot par l'intermédiaire de l'une des deuxièmes articulations pivot (16b).

15. Système (2) selon l'une quelconque des revendications 1 à 14, dans lequel les moyens capacitifs de mesure ou d'actionnement (15') comprennent :

- une première électrode mobile (151) par rapport au bâti (10) ; et
- au moins une électrode fixe (153, 154) par rapport au bâti (10) et séparée de la première électrode mobile (151) par un premier milieu diélectrique.

16. Système (2) selon la revendication 15, dans lequel l'élément mobile (13) est en contact avec une première zone (11) et la première électrode mobile (151) est située dans une deuxième zone (12) isolée de manière étanche de la première zone (11).

17. Système (2) selon l'une des revendications 15 et 16, dans lequel :

- au moins une des premières articulations pivot (16a) est située au niveau de la première électrode mobile (151) ;
- une autre des premières articulations pivot (16a) est située à une extrémité du premier dispositif de transmission (14a) et relie le premier dispositif de transmission (14a) au premier îlot (110).

18. Système (2) selon l'une quelconque des revendications 15 à 17, dans lequel les moyens capacitifs de mesure ou d'actionnement (15') comprennent en outre :

- une deuxième électrode mobile (152) par rapport au bâti (10) ; et
- au moins une électrode additionnelle fixe par rapport au bâti (10) et séparée de la deuxième électrode mobile (152) par un deuxième milieu diélectrique.

**Fig. 1**

**Fig. 2**

**Fig. 3**

Fig. 4A

Fig. 4B

**Fig. 5**

EP 4 657 890 A1

Fig. 6

Fig. 7A

Fig. 7B

Fig. 8

**Fig. 9**

EP 4 657 890 A1

Fig. 10

EP 4 657 890 A1

**EP 4 657 890 A1**

Europäisches
Patentamt

European
Patent Office

Office européen
des brevets

# RAPPORT DE RECHERCHE EUROPEENNE

Numéro de la demande

EP 25 17 8633

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2019/308873 A1 (JOET LOIC [FR]) 10 octobre 2019 (2019-10-10) * alinéa [0071] - alinéa [0111] * ----- | 1-18 | INV. H04R19/00 B81B3/00 |
| A | US 2022/098032 A1 (JOET LOÏC [FR]) 31 mars 2022 (2022-03-31) * alinéa [0002]; figure 1 * * alinéa [0062] - alinéa [0072] * ----- | 1-18 | ADD. H04R19/01 B81B5/00 |
| A | US 2010/135123 A1 (FISCHER FRANK [DE] ET AL) 3 juin 2010 (2010-06-03) * alinéas [0005], [0022]; figures 1,2 * ----- | 1-18 | |

**DOMAINES TECHNIQUES RECHERCHES (IPC)**

H04R
B82B
B81B

Le présent rapport a été établi pour toutes les revendications

| Lieu de la recherche | Date d'achèvement de la recherche | Examinateur |
|---|---|---|
| La Haye | 17 septembre 2025 | Carrière, Olivier |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................................
& : membre de la même famille, document correspondant

EPO FORM 1503 03.82 (P04C02)

**EP 4 657 890 A1**

## ANNEXE AU RAPPORT DE RECHERCHE EUROPEENNE
## RELATIF A LA DEMANDE DE BREVET EUROPEEN NO.

EP 25 17 8633

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-09-2025

| Document brevet cité au rapport de recherche | Date de publication | Membre(s) de la famille de brevet(s) | | Date de publication |
|---|---|---|---|---|
| US 2019308873 A1 | 10-10-2019 | CN | 110049942 A | 23-07-2019 |
| | | EP | 3538479 A1 | 18-09-2019 |
| | | ES | 2916839 T3 | 06-07-2022 |
| | | FR | 3059659 A1 | 08-06-2018 |
| | | US | 2019308873 A1 | 10-10-2019 |
| | | WO | 2018104656 A1 | 14-06-2018 |
| US 2022098032 A1 | 31-03-2022 | CN | 114339559 A | 12-04-2022 |
| | | EP | 3975584 A1 | 30-03-2022 |
| | | FR | 3114584 A1 | 01-04-2022 |
| | | US | 2022098032 A1 | 31-03-2022 |
| US 2010135123 A1 | 03-06-2010 | AT | E483329 T1 | 15-10-2010 |
| | | DE | 102007029911 A1 | 02-01-2009 |
| | | EP | 2163121 A1 | 17-03-2010 |
| | | JP | 2010531592 A | 24-09-2010 |
| | | US | 2010135123 A1 | 03-06-2010 |
| | | WO | 2009000641 A1 | 31-12-2008 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3114584 B1
- FR 3059659 B1